# EUROPEAN PATENT APPLICATION

(11) **EP 4 776 792 A1**
(43) Date of publication of application: **15.07.2026**
(21) Application number: 25227409.7
(22) Date of filing: 29.12.2025
(51) Int. Cl.: H10F 10/166, H10F 71/10, H10F 71/00

(54) **HETEROJUNCTION SOLAR CELL AND PREPARATION METHOD THEREOF**

(30) Priority: 08.01.2025 CN 202520039323 U; 08.01.2025 CN 202510026787; 25.09.2025 EP 25204620
(71) Applicant: Canadian Solar Sunenergy (Jiaxing) Co. Ltd, Jiaxing City, Zhejiang Province (CN)
(72) Inventor: YAO, Zheng, JIANGSU, 215000 (CN); ZHANG, Qiang, JIANGSU, 215000 (CN); ZHANG, Daqi, JIANGSU, 215000 (CN); WU, Jian, JIANGSU, 215000 (CN)
(74) Representative: Kransell & Wennborg KB

(57) **Abstract**

Provided are a heterojunction solar cell, a preparation method thereof, and a photovoltaic module. The heterojunction solar cell includes: a silicon substrate having a first surface, a second surface opposite to the first surface, and a sidewall surface; at least one backside intrinsic layer, a backside doped layer, a second transparent conductive oxide layer, and a second electrode that are sequentially stacked on the first surface, the backside doped layer being further disposed on the sidewall surface; at least one frontside intrinsic layer, a frontside doped layer, a first transparent conductive oxide layer, and a first electrode that are sequentially stacked on the second surface, the frontside doped layer being further disposed on the sidewall surface; and a first intrinsic layer disposed between the frontside doped layer and the backside doped layer on the sidewall surface.

## Description

### CROSS-REFERENCE TO RELATED APPLICATION

This application claims priority to and benefits of Chinese patent applications No. 202520039323.5 filed with China National Intellectual Property Administration on January 8, 2025 and No. 202510026787.7 filed with China National Intellectual Property Administration on January 8, 2025, the entire contents of which are incorporated herein by reference.

### FIELD

The present disclosure belongs to the field of photovoltaic technologies, and relates to a heterojunction solar cell, a preparation method thereof, and a photovoltaic module.

### BACKSIDEGROUND

With the widespread application of solar cell modules, photovoltaic power generation has increasingly occupied an important proportion in new energy and has achieved rapid development. Among currently commercialized solar cell products, crystalline silicon (monocrystalline and polycrystalline) solar cells hold the largest market share, having consistently maintained a market share of more than 85%. Therefore, developing cost-effective crystalline silicon solar cells remains one of research and development directions for researchers worldwide.

Currently, Sanyo Electric Co., Ltd., produces a crystalline silicon heterojunction solar cell. The term "heterojunction" refers to a structure where a PN junction on a frontside of the cell is formed by amorphous silicon and an N-type monocrystalline silicon substrate. An amorphous silicon layer includes a P-type amorphous silicon thin film layer and an intrinsic amorphous silicon thin film layer. On a backside of the cell, a back surface field is formed by an intrinsic amorphous silicon thin film layer and an N-type amorphous silicon thin film layer. As a direct bandgap semiconductor material, the amorphous silicon has a high absorption coefficient of incident light. A very small thickness amorphous silicon thin film layer can absorb a considerable portion of the incident light. At the same time, the amorphous silicon has a bandgap width of 1.7 eV, which is much larger than a 1.1 eV bandgap width of crystalline silicon. Therefore, an open circuit voltage of a heterojunction structure solar cell can be significantly higher than that of conventional crystalline silicon solar cells, leading to excellent performance.

Heterojunction high-efficiency solar cells have advantages over other types in terms of an intrinsic amorphous layer, which provide both efficient passivation and tunneling. An interior of the intrinsic amorphous layer serves to suppress epitaxial growth to achieve effective passivation, and an exterior of the intrinsic amorphous layer forms an effective contact with a corresponding doped layer. At this stage, it is found that the tunneling contact on the backside of the cell significantly affects Current-Voltage, IV performance of the cell and directly correlates with thermal degradation. Thus, achieving better tunneling contact has become particularly crucial. In addition, due to a relatively thin silicon wafer substrate used in the heterojunction solar cells and limited coating process accuracy, edge short circuits or leakage currents of the heterojunction solar cells are prone to occur.

Therefore, for the heterojunction solar cells, achieving superior tunneling contact while reducing probability of the edge short circuits or reducing the leakage currents has become an urgent priority for current research.

### SUMMARY

In view of the shortcomings in the related art, an object of the present disclosure is to provide a heterojunction solar cell, a preparation method thereof, and a photovoltaic module. In the present disclosure, through synthetic combination of composite arrangement of multiple backside intrinsic layers on a surface of a silicon substrate and optimized film layer structures at sidewalls of the silicon substrate, an insulation performance of the heterojunction solar cell is improved, and the heterojunction solar cell exhibits better tunneling contact and reduced thermal degradation, thereby achieving a significant improvement in a photoelectric conversion effect of the cell.

To achieve this object, the present disclosure adopts the following technical solutions.

In a first aspect, the present disclosure provides a heterojunction solar cell. The heterojunction solar cell includes a silicon substrate; a frontside intrinsic layer, a frontside doped layer, a first transparent conductive oxide layer, and a first electrode that are sequentially stacked on a surface of a main light-receiving surface of the silicon substrate in a thickness direction of the silicon substrate; a first backside intrinsic layer, a second backside intrinsic layer, a backside doped layer, a second transparent conductive oxide layer, and a second electrode that are sequentially stacked on the other surface of the silicon substrate opposite to the main light-receiving surface in the thickness direction of the silicon substrate; the frontside doped layer, the second backside intrinsic layer, and the backside doped layer stacked on a sidewall surface of the silicon substrate from inside to outside in horizontal direction perpendicular to the thickness direction of the silicon substrate.

In the heterojunction solar cell according to the present disclosure, the second backside intrinsic layer is disposed between the backside doped layer (a p layer) and the first backside intrinsic layer, ensuring that there is no damage on the outermost backside intrinsic layer in contact with the p-doped layer, thus obtaining a low-resistance and stable tunneling contact. Moreover, the silicon substrate is also provided with a film layer structure at the sidewall of the silicon substrate, especially it is ensured that there is at least one backside intrinsic layer structure between the frontside doped layer (an n layer) and the backside doped layer (the p layer), making the insulation performance of the cell more excellent. Through the synthetic coordination of the stacking order of the film layers in the cell structure and the specific types of the structural layers, the insulation performance of the heterojunction solar cell is improved, and thus the heterojunction solar cell exhibits better tunneling contact and reduced thermal degradation. In this way, a significant improvement in the photoelectric conversion effect of the cell is achieved.

The following are preferred technical solutions of the present disclosure, but shall not be construed as limitations on the technical solutions according to the present disclosure. The following preferred technical solutions can better achieve and realize the technical objects and beneficial effects of the present disclosure.

As a preferred technical solution in the present disclosure, the silicon substrate includes an N-type silicon substrate. The N-type silicon substrate has a resistivity ranging from 0.5 Q.cm to 3 Ω.cm, for example, 0.5 Ω.cm, 1 Ω.cm, 1.5 Ω.cm, 2 Ω.cm, 2.5 Ω.cm, or 3 Ω.cm. The N-type silicon substrate has a thickness ranging from 90 µm to 120 µm, for example, 90 µm, 95 µm, 100µm, 105 µm, 110 µm, 115 µm, or 120 µm.

The heterojunction solar cell according to the present disclosure uses the N-type silicon substrate, which features higher quality and a longer minority carrier lifetime. The back junction heterojunction solar cell obtained therefrom thus has higher conversion efficiency.

As a preferred technical solution in the present disclosure, in the horizontal direction perpendicular to the thickness direction of the silicon substrate, the frontside doped layer disposed on the sidewall surface of the silicon substrate has a thickness ranging from 0.5 nm to 2 nm, for example, 0.5 nm, 0.6 nm, 0.7 nm, 0.8 nm, 0.9 nm, 1 nm, 1.1 nm, 1.2 nm, 1.3 nm, 1.4 nm, 1.5 nm, 1.6 nm, 1.7 nm, 1.8 nm, 1.9 nm, or 2 nm.

As a preferred technical solution in the present disclosure, in the horizontal direction perpendicular to the thickness direction of the silicon substrate, the second backside intrinsic layer disposed on the sidewall surface of the silicon substrate has a thickness ranging from 0.5 nm to 2 nm, for example, 0.5 nm, 0.6 nm, 0.7 nm, 0.8 nm, 0.9 nm, 1 nm, 1.1 nm, 1.2 nm, 1.3 nm, 1.4 nm, 1.5 nm, 1.6 nm, 1.7 nm, 1.8 nm, 1.9 nm, or 2 nm.

As a preferred technical solution in the present disclosure, in the horizontal direction perpendicular to the thickness direction of the silicon substrate, the backside doped layer disposed on the sidewall surface of the silicon substrate has a thickness ranging from 0.5 nm to 2 nm, for example, 0.5 nm, 0.6 nm, 0.7 nm, 0.8 nm, 0.9 nm, 1 nm, 1.1 nm, 1.2 nm, 1.3 nm, 1.4 nm, 1.5 nm, 1.6 nm, 1.7 nm, 1.8 nm, 1.9 nm, or 2 nm.

In the present disclosure, the film layer structure is disposed at the sidewall of the silicon substrate in the horizontal direction perpendicular to the thickness direction of the silicon substrate. The frontside doped layer has a thickness ranging from 0.5 nm to 2 nm; and/or the second backside intrinsic layer has a thickness ranging from 0.5 nm to 2 nm; and/or the backside doped layer has a thickness ranging from 0.5 nm to 2 nm. By further defining the thickness of the above-mentioned film layer structure, a good insulation performance can be achieved, and the thickness of the sidewall film layer can be avoided from being too thick, which would otherwise affect good performance of the heterojunction solar cell.

As a preferred technical solution in the present disclosure, in the horizontal direction perpendicular to the thickness direction of the silicon substrate, the first backside intrinsic layer, the frontside intrinsic layer, the frontside doped layer, the second backside intrinsic layer, and the backside doped layer are disposed at the sidewall surface of the silicon substrate from inside to outside.

In the present disclosure, in addition to the frontside doped layer, the second backside intrinsic layer, and the backside doped layer, the first backside intrinsic layer and the frontside intrinsic layer may also be provided on the sidewall of the silicon substrate, which can better improve the insulation performance.

As a preferred technical solution in the present disclosure, in the horizontal direction perpendicular to the thickness direction of the silicon substrate, the first backside intrinsic layer disposed on the sidewall surface of the silicon substrate has a thickness ranging from 0.5 nm to 2 nm, for example, 0.5 nm, 0.6 nm, 0.7 nm, 0.8 nm, 0.9 nm, 1 nm, 1.1 nm, 1.2 nm, 1.3 nm, 1.4 nm, 1.5 nm, 1.6 nm, 1.7 nm, 1.8 nm, 1.9 nm, or 2 nm.

As a preferred technical solution in the present disclosure, in the horizontal direction perpendicular to the thickness direction of the silicon substrate, the frontside intrinsic layer disposed on the sidewall surface of the silicon substrate has a thickness ranging from 0.5 nm to 2 nm, for example, 0.5 nm, 0.6 nm, 0.7 nm, 0.8 nm, 0.9 nm, 1 nm, 1.1 nm, 1.2 nm, 1.3 nm, 1.4 nm, 1.5 nm, 1.6 nm, 1.7 nm, 1.8 nm, 1.9 nm, or 2 nm.

As a preferred technical solution in the present disclosure, a first transparent conductive oxide layer is further provided on a surface of the backside doped layer away from the silicon substrate in the horizontal direction perpendicular to the thickness direction of the silicon substrate.

As a preferred technical solution in the present disclosure, in the horizontal direction perpendicular to the thickness direction of the silicon substrate, the first transparent conductive oxide layer disposed on the sidewall surface of the silicon substrate has a thickness ranging from 0.5 nm to 20 nm, for example, 0.5 nm, 0.6 nm, 0.7 nm, 0.8 nm, 0.9 nm, 1 nm, 1.1 nm, 1.2 nm, 1.3 nm, 1.4 nm, 1.5 nm, 1.6 nm, 1.7 nm, 1.8 nm, 1.9 nm, 2 nm, 4nm, 6nm, 8nm, 10nm, 12nm, 14nm, 16nm, 18nm, 20nm.

As a preferred technical solution in the present disclosure, in the thickness of the silicon substrate, the frontside intrinsic layer has a thickness ranging from 4.5 nm to 7.5 nm, for example, 4.5 nm, 5 nm, 5.5 nm, 6 nm, 6.5 nm, 7 nm, or 7.5 nm.

As a preferred technical solution in the present disclosure, in the thickness direction of the silicon substrate, the frontside doped layer has a thickness ranging from 25 nm to 35 nm, for example, 25 nm, 26 nm, 27 nm, 28 nm, 29 nm, 30 nm, 31 nm, 32 nm, 33 nm, 34 nm or 35 nm.

In the present disclosure, both the frontside intrinsic layer and the frontside doped layer are conventional technical solutions, and the specific types of the film layers known to those skilled in the art within a reasonable range are applicable to the present disclosure.

For example, the frontside intrinsic layer may be an intrinsic amorphous silicon film layer, and the frontside doped layer may include at least one of an n-type doped microcrystalline silicon film layer, an n-type doped amorphous silicon film layer, or an n-type microcrystalline amorphous hybrid doped film layer. The n-type represents a positive junction.

In addition, specific deposition conditions in the front intrinsic amorphous silicon film layer, the n-type doped microcrystalline silicon film layer and/or the n-type doped amorphous silicon film layer can adaptively selected and adjusted by those skilled in the art according actual needs.

As a preferred technical solution in the present disclosure, in the thickness direction of the silicon substrate, the first backside intrinsic layer has a thickness ranging from 1 nm to 2 nm, for example, 1 nm, 1.1 nm, 1.2 nm, 1.3 nm, 1.4 nm, 1.5 nm, 1.6 nm, 1.7 nm, 1.8 nm, 1.9 nm, or 2 nm.

The specific types of the first backside intrinsic layer and the second backside intrinsic layer are not specifically limited in the present disclosure. The types of the intrinsic layers known to those skilled in the art within a reasonable range are applicable to the present disclosure.

For example, the first backside intrinsic layer may be selected from an intrinsic amorphous silicon film layer, and the second backside intrinsic layer may be selected from at least one of an intrinsic hydrogenated amorphous silicon film layer, an intrinsic amorphous silicon film layer, an intrinsic hydrogenated microcrystalline silicon film layer, or an intrinsic microcrystalline silicon film layer. Preferably, the second backside intrinsic layer is subjected to hydrogenation treatment.

In the present disclosure, an R value of the first backside intrinsic layer close to a surface of the silicon substrate is low, which has a better passivation effect. The second backside intrinsic layer far from the surface of the silicon substrate is subjected to high-hydrogen dilution and high-oxygen doping, facilitating microcrystalline nucleation and further facilitating obtaining of a back P-layer with a higher crystallization rate. Thus, the heterojunction solar cell has higher bandgap energy (Eg).

As a preferred technical solution in the present disclosure, in the thickness direction of the silicon substrate, the second back surface intrinsic layer has a thickness ranging from 3 nm to 6 nm, for example, 3 nm, 3.3 nm, 3.5 nm, 3.8 nm, 4 nm, 4.3 nm, 4.5 nm, 4.8 nm, 5 nm, 5.3 nm, 5.5 nm, 5.8 nm, or 6 nm.

In the present disclosure, by regulating the thickness of the first backside intrinsic layer to range from 1 nm to 2 nm and/or the thickness of the second backside intrinsic layer to range from 3 nm to 6 nm, an outermost intrinsic layer in contact with the frontside doped layer can be made without damage, facilitating obtaining of a low-resistance and stable tunneling contact.

As a preferred technical solution in the present disclosure, in the thickness direction of the silicon substrate, the backside doped layer has a thickness ranging from 25 nm to 35 nm, for example, 25 nm, 26 nm, 27 nm, 28 nm, 29 nm, 30 nm, 31 nm, 32 nm, 33 nm, 34 nm or 35 nm.

In the present disclosure, both the backside intrinsic layer and the backside doped layer are conventional technical solutions, and the specific types of the film layers known to those skilled in the art within a reasonable range are applicable to the present disclosure.

For example, the backside intrinsic layer may be an intrinsic amorphous silicon film layer, and the backside doped layer may include at least one of a p-type doped microcrystalline silicon film layer, a p-type doped amorphous silicon film layer, or a spectral microcrystalline amorphous hybrid doped film layer. The p-type represents a back junction.

It should be noted that the p-type doped microcrystalline silicon film layer and/or the p-type doped amorphous silicon film layer in the present disclosure are conventional film layer structures that can be obtained in the related art. Those skilled in the art can adjust an inflow flow rate of silane gas, hydrogen gas, and doped gas as well as the type of the doped gas according to actual needs to obtain the desired p-type amorphous silicon film layer.

As a preferred technical solution in the present disclosure, in the thickness direction of the silicon substrate, the first transparent conductive oxide layer and the second transparent conductive oxide layer each independently have a thickness ranging from 40 nm to 120 nm, for example, 40 nm, 50 nm, 60 nm, 70 nm, 80 nm, 90 nm, 100 nm, 110 nm, or 120 nm.

In a second aspect, the present disclosure provides a method for preparing a heterojunction solar cell. The method includes:
step (1) of depositing a first backside intrinsic layer on a surface of either side of the silicon substrate;
step (2) of depositing a frontside intrinsic layer and a frontside doped layer sequentially on a surface of the other side of the silicon substrate;
step (3) of depositing a second backside intrinsic layer and a backside doped layer sequentially on the surface of the first backside intrinsic layer;
step (4) of depositing a transparent conductive oxide layer on each of the frontside doped layer and the backside doped layer; and
step (5) of preparing an electrode on each of the transparent conductive oxide layer on a frontside and a transparent conductive oxide layer on a backside to obtain the heterojunction solar cell.

It should be noted that the surface of either side described in step (1) of the present disclosure is a main light-receiving surface of the silicon substrate, and the surface of the other side described in step (2) refers to a surface opposite to the surface of either side described in step (1).

In the preparation method according to the present disclosure, with the synthetic coordination of the preparation sequence and the structural layers, destruction of the intrinsic layer is avoided when flipping the silicon substrate for frontside coating (i.e., the light-receiving surface) by preparing the backside intrinsic layer in steps, ensuring that an outermost backside intrinsic layer in contact with the backside doped layer remains intact. Thus, the solar cell structure with the low-resistance and stable tunneling contact is obtained, and its thermal degradation is also reduced.

In the present disclosure, the preparation sequence and the structural layers are synthetically coordinated, neither of which are dispensable. If the preparation sequence of the backside intrinsic layer, the frontside intrinsic layer, the frontside doped layer, the backside doped layer is adopted, it is impossible to keep the intrinsic layer in contact with the backside doped layer undamaged, resulting in a large contact resistance. If the preparation sequence of the frontside intrinsic layer, the backside intrinsic layer, the frontside doped layer, the backside doped layer is adopted, all the inner intrinsic layers are damaged. That is to say, in the present disclosure, the required high-quality intrinsic layers can only be obtained by first depositing a part of the backside intrinsic layer.

The following are preferred technical solutions of the present disclosure, but shall not be construed as limitations on the technical solutions according to the present disclosure. The following preferred technical solutions can better achieve and realize the technical objects and beneficial effects of the present disclosure.

Preferably, in step (1), texturing treatment are performed on the surfaces of two sides of the silicon substrate first prior to depositing the first backside intrinsic layer.

A specific preparation process of the texturing treatment is not specifically limited in the present disclosure, all conventional technical solutions that can be used for the texturing of the silicon substrate are applicable to the present disclosure.

Exemplarily, the present disclosure provides a texturing treatment method. The method specifically includes: removing an oxide layer on a surface of the silicon substrate using a 5% diluted hydrofluoric acid (HF) solution; and using an alkaline texturing agent combined with alcohol to form shallow pyramidal structures on the surface of the silicon substrate through anisotropic etching of monocrystalline silicon, thereby completing the texturing treatment on the surfaces of two sides of the silicon substrate.

Further, the texturing agent includes at least one of potassium hydroxide (KOH), sodium hydroxide (NaOH), or tetramethyl ammonia hydroxide (TMAH).

Preferably, step (1) includes: depositing the first backside intrinsic layer on the surface of either side of the silicon substrate.

Preferably, during the deposition of the first backside intrinsic layer, an inlet flow rate of the first silane ranges from 800 sccm to 1000 sccm; a pressure ranges from 0.4 Torr to 0.6 Torr; and a deposition power ranges from 500W to 1000W.

For example, the inlet flow rate of the first silane gas may be 800 sccm, 850 sccm, 900 sccm, 950 sccm, or 1000 sccm, etc.; the pressure may be 0.4 Torr, 0.45 Torr, 0.5 Torr, 0.55 Torr, or 0.6 Torr, etc.; and the deposition power may be 500 W, 550 W, 600 W, 650 W, 700 W, 750 W, 800 W, 850 W, 900 W, 950 W, or 1000 W, etc.

Preferably, a deposition thickness of the first back surface intrinsic layer ranges from 1 nm to 2 nm, for example, 1 nm, 1.1 nm, 1.2 nm, 1.3 nm, 1.4 nm, 1.5 nm, 1.6 nm, 1.7 nm, 1.8 nm, 1.9 nm, or 2 nm.

In the present disclosure, the deposition of the first backside intrinsic layer is carried out in a high silicon environment by regulating the deposition process of the first backside intrinsic layer, thereby improving a passivation effect of the first backside intrinsic layer. Moreover, an intrinsic amorphous passivation effect can be better achieved by further regulating the inlet flow rate of the first silane gas to range from 800 sccm to 1000 sccm and/or the deposition thickness of the first backside intrinsic layer to range from 1 nm to 2 nm.

Preferably, in step (1), while depositing on the surface of either side of the silicon substrate, depositing on the sidewall of the silicon substrate in a direction perpendicular to the thickness of the silicon substrate.

In the present disclosure, while depositing the first backside intrinsic layer on the surface of either side of the silicon substrate, the backside intrinsic layer can also be deposited on the sidewall in the direction perpendicular to the thickness direction of the silicon substrate under the same deposition conditions, to obtain the first backside intrinsic layer on the sidewall of the silicon substrate.

Preferably, step (2) includes: depositing, by introducing second silane gas, the frontside intrinsic layer on the surface of the other side of the silicon substrate; and depositing, by introducing second silane gas, first hydrogen gas, and first doping gas, the frontside doped layer on the frontside intrinsic layer.

Preferably, during the deposition process of the frontside intrinsic layer, an inlet flow rate of the second silane gas ranges from 500 sccm to 1000 sccm, a pressure ranges from 0.4 Torr to 0.6 Torr, and a deposition power ranges from 200 W to 600W.

For example, during the deposition of the frontside intrinsic layer, the inlet flow rate of the second silane gas may be 500 sccm, 550 sccm, 600 sccm, 650 sccm, 700 sccm, 750 sccm, 800 sccm, 850 sccm, 900 sccm, 950 sccm, or 1000 sccm, etc.; the pressure may be 0.4 Torr, 0.45 Torr, 0.5 Torr, 0.55 Torr, or 0.6 Torr, etc.; and the deposition power may be 200 W, 300 W, 400 W, 500 W, or 600 W, etc.

Preferably, during the deposition of the frontside doped layer, an inlet flow rate of the second silane gas ranges from 40 sccm to 70 sccm; an inlet flow rate of the first hydrogen ranges from 12000 sccm to 16000 sccm; an inlet flow rate of the first doped gas ranges from 200 sccm to 500 sccm; a pressure ranges from 4 Torr to 6 Torr; and a deposition power ranges from 2000 W to 5000 W.

For example, during the deposition of the frontside doped layer, the inlet flow rate of the second silane gas may be 40 sccm, 45 sccm, 50 sccm, 55 sccm, 60 sccm, 65 sccm or 70 sccm, etc.; the inlet flow rate of the first doped gas may be 12000 sccm, 13000 sccm, 14000 sccm, 15000 sccm, or 16000 sccm, etc.; the pressure may be 4 Torr, 4.5 Torr, 5 Torr, 5.5 Torr, or 6 Torr, etc.; and the deposition power may be 2000 W, 3000 W, 4000 W, or 5000 W, etc.

In the present disclosure, the methods of the deposition of the frontside intrinsic layer and the frontside doped layer on the surface of the other side of the silicon substrate are conventional technical solutions. Those skilled in the art can select and adjust the above-mentioned preparation parameters and gas types according to actual needs.

For example, the first doping gas may be phosphine (PH₃) gas.

It is further preferred that the frontside intrinsic layer has a thickness ranging from 5 nm to 8 nm (for example, 5 nm, 5.5 nm, 6 nm, 6.5 nm, 7 nm, 7.5 nm, or 8 nm), and the frontside doped layer has a thickness ranging from 22 nm to 28 nm, for example, 22 nm, 23 nm, 24 nm, 25 nm, 26 nm, 27 nm, or 28 nm.

Preferably, in step (2), while depositing on the surface of either side of the silicon substrate, depositing on the sidewall surface of the silicon substrate in the direction perpendicular to the thickness direction of the silicon substrate.

Preferably, step (3) includes: depositing, by introducing third silane gas and second hydrogen gas, the second backside intrinsic layer on the first backside intrinsic layer; and depositing, by introducing fourth silane gas, third hydrogen gas, and second doping gas, the backside doped layer on the second backside intrinsic layer.

Preferably, during the deposition of the second back surface intrinsic layer, a ratio of an inlet flow rate of the second hydrogen gas to an inlet flow rate of the third silane gas ranges from 1:1 to 5:1, for example, 1:1, 1.5:1, 2:1, 2.5:1, 3:1, 3.5:1, 4:1, 4.5:1, or 5:1.

**In** the present disclosure, during the deposition of the second backside intrinsic layer, high hydrogen gas and high-oxygen doping are carried out to facilitate microcrystal nucleation. This in turn facilitates an increase in a crystallization rate of the subsequent backside doped layer. As a result, the backside doped layer has larger bandgap energy (Eg). Further, an amorphous passivation layer can be better obtained by regulating the ratio of the inlet flow rate of the second hydrogen gas to the inlet flow rate of the third silane to range from 1:1 to 5:1.

Preferably, during the deposition of the second backside intrinsic layer, an inlet flow rate of the second hydrogen gas ranges from 500 sccm to 5000 sccm; a pressure ranges from 0.4 Torr to 0.6 Torr; and a deposition power ranges from 100W to 300W.

For example, the inlet flow rate of the third silane gas may be 500 sccm, 600 sccm, 700 sccm, 800 sccm, 900 sccm, or 1000 sccm, etc.; the inlet flow rate of the second hydrogen gas may be 500 sccm, 1000 sccm, 1500 sccm, 2000 sccm, 2500 sccm, 3000 sccm, 3500 sccm, 4000 sccm, 4500 sccm, or 5000 sccm, etc.; the pressure may be 0.4 Torr, 0.45 Torr, 0.5 Torr, 0.55 Torr, or 0.6 Torr, etc.; and the deposition power may be 100 W, 150 W, 200 W, 250 W, or 300 W, etc.

**In** the present disclosure, it is more conducive to contacting the outer backside (the p-type) doped layer by further regulating the inlet flow rate of the third silane gas to range from 500 sccm to1000 sccm and/or the inlet flow rate of the second hydrogen gas to range from 500 sccmsccm to 5000 sccmsccm.

Preferably, the first back surface intrinsic layer has a thickness ranging from 3 nm to 6 nm, for example, 3 nm, 3.5 nm, 4 nm, 4.5 nm, 5 nm, 5.5 nm, 6 nm.

**In** the present disclosure, the thickness of the second backside intrinsic layer is thicker than that of the first backside intrinsic layer, further enhancing the passivation of the intrinsic layer and improving the contact effect. Moreover, effective doping of the P-type doped layer can be further improved by regulating the thickness of the second backside intrinsic layer to range from 3 nm to 6 nm.

Preferably, during the deposition of the backside doped layer, an inlet flow rate of the fourth silane gas ranges from 50 sccm to 80 sccm; an inlet flow rate of the third hydrogen gas ranges from 18000 sccm to 25000 sccm; an inlet flow rate of the second doped gas ranges from 30 sccm to 200 sccm; a pressure ranges from 4 Torr to 6 Torr; and a deposition power ranges from 5000 W to 8000 W.

For example, during the deposition of the backside doped layer, the inlet flow rate of the fourth silane gas may be 50 sccm, 60 sccm, 70 sccm, or 80 sccm, etc.; the inlet flow rate of the third hydrogen gas may be 18000 sccm, 19000 sccm, 20000 sccm, 21000 sccm, 22000 sccm, 23000 sccm, 24000 sccm, or 25000 sccm, etc.; the inflow flow rate of the second doping gas may be 30 sccm, 50 sccm, 75 sccm, 100 sccm, 125 sccm, 150 sccm, 175 sccm, or 200 sccm, etc.; the pressure may be 4 Torr, 4.5 Torr, 5 Torr, 5.5 Torr, or 6 Torr, etc.; and the deposition power may be 5000 W, 6000 W, 7000 W, or 8000 W, etc.

In the present disclosure, the preparation process and preparation parameters of the backside doped layer are conventional technical solutions, which can be adaptively selected and adjusted by those skilled in the art according to actual needs.

It is further preferred that the backside doped layer has a thickness ranging from 24 nm to 35 nm, for example, 24 nm, 25 nm, 26 nm, 27 nm, 28 nm, 29 nm, 30 nm, 31 nm, 32 nm, 33 nm, 34 nm, or 35 nm.

Preferably, in step (2), while depositing on the surface of the first backside intrinsic layer, depositing on the sidewall in the direction perpendicular to the thickness direction of the silicon substrate.

In the present disclosure, during each of the deposition of step (1), step (2), and step (3), the deposition of the film layers on the sidewall of the silicon substrate in the direction perpendicular to the thickness direction of the silicon substrate can be carried out simultaneously under corresponding same deposition conditions. That is, in the direction perpendicular to the thickness direction of the silicon substrate, the first backside intrinsic layer, the frontside intrinsic layer, the frontside doped layer, the second backside intrinsic layer, and the backside doped layer may be sequentially disposed on the sidewall surface, and thus at least one second backside intrinsic layer is disposed between the frontside doped layer (the n layer) and the backside doped layer (the p layer).

In addition, the film layer structure is also deposited on the sidewall surface of the silicon substrate in the direction perpendicular to the thickness direction of the silicon substrate, and at least one backside intrinsic layer is disposed between the n layer and the p layer. As a result, the insulation performance is better, and the leakage currents of the cell are more effectively solved. Thus, performance of the cell is further improved.

It is further preferred that in the film layer structures deposited in the sidewall of the silicon substrate in the direction perpendicular to the thickness direction of the silicon substrate, each of the layer structures independently has a thickness ranging from 0.5 nm to 2 nm, for example, 0.5 nm, 0.6 nm, 0.7 nm, 0.8 nm, 0.9 nm, 1 nm, 1.1 nm, 1.2 nm, 1.3 nm, 1.4 nm, 1.5 nm, 1.6 nm, 1.7 nm, 1.8 nm, 1.9 nm, or 2 nm.

Preferably, in step (4), the transparent conductive oxide layer has a thickness ranging from 30 nm to 60 nm, for example, 30 nm, 35 nm, 40 nm, 45 nm, 50 nm, 55 nm or 60 nm.

It should be noted that the method for preparing the film layer as the transparent conductive oxide layer in the present disclosure is a conventional technical solution, and the method that can be known to those skilled in the art within a reasonable range is applicable to the present disclosure.

Exemplarily, the present disclosure provides a method for preparing a film layer as a transparent conductive oxide layer. The method specifically includes: coating the surface of each of the frontside doped layer and the backside doped layer using reactive plasma deposition (RPD) or magnetron sputtering. For the backside, edge shielding was implemented through a carrier disc design (via mask shielding). A specific shielding region around the perimeter ranges from 0.5 mm to 0.8 mm (such as 0.5 mm, 0.6 mm, 0.7 mm, or 0.8mm).

Further, the transparent conductive oxide layer is made of ITO (In2O3:XO2=99.5:0.5 wt%), which has a carrier concentration ranging from 2E20/cm³ to 5E20/cm³ (e.g., 2E20/cm³, 2.5E20/cm³, 3E20/cm³, 3.5E20/cm³, 4E20/cm³, 4.5E20/cm³, or 5E20/cm³), and a mobility greater than 80cm²/Vs (e.g., 80 cm²/Vs, 85 cm²/Vs, 90 cm²/Vs, 95 cm²/Vs or 100 cm²/Vs).

Preferably, in step (5), the electrode is prepared by a screen-printed electrode preparation method.

Preferably, in step (5), the method further includes: performing light injection treatment subsequent to side preparing the electrode, to obtain the heterojunction solar cell.

It can be understood that the electrode preparation method and the light injection method in the present disclosure are also conventional technical solutions, which can be adaptively selected and adjusted by those skilled in the art according to actual needs.

Exemplarily, the present disclosure provides a method for electrode preparation and light injection treatment, which specifically includes the following.

Electrode preparation: A layer of low-temperature conductive silver paste is printed on the transparent conductive oxide film on each of the frontside and backside using a screen printing method, and then sintering and curing are performed at a low temperature ranging from 150°C to 300°C (e.g., 150°C, 175°C, 200°C, 225°C, 250°C, 275°C, or 300°C) to form good ohmic contact, to complete the electrode preparation.

Light injection treatment: After electrode preparation, the obtained cell is then subjected to light injection treatment. A temperature of the light injection treatment ranges from 200°C to 220°C (e.g., 200°C, 210°C, or 220°C), and a duration of the light injection treatment ranges from 60 seconds to 120 seconds (e.g., 60 seconds, 70 seconds, 80 seconds, 90 seconds, 100 seconds, 110 seconds, or 120 seconds).

It should also be noted that the silicon substrate in the present disclosure is an N-type silicon substrate. The N-type silicon substrate has a resistivity ranging from 0.5 Ω.cm to 3 Ω.cm (e.g., 0.5 Ω.cm, 1 Ω.cm, 1.5 Ω.cm, 2 Ω.cm, 2.5 Ω.cm or 3 Ω.cm), a thickness ranging from 90 µm to 120 µm (e.g., 90 µm, 95 µm, 100 µm, 105 µm, 110 µm, 115 µm, or 120 µm), and a size of 210 mm.

Specifically, the type of the silicon substrate includes, but is not limited to, an N-type crystalline silicon wafer.

In addition, it should be noted that the pressure in the present disclosure refers to a deposition pressure during deposition of the film layer, i.e., an absolute pressure value in a film layer deposition system.

In a third aspect, the present disclosure provides a heterojunction solar cell prepared by the method according to the first aspect.

In the heterojunction solar cell according to the present disclosure, a frontside intrinsic layer, a frontside doped layer, a transparent conductive oxide layer, and an electrode are sequentially stacked on a surface of either side of the silicon substrate (in a thickness direction of the silicon substrate). A first backside intrinsic layer, a second backside intrinsic layer, a backside doped layer, a transparent conductive oxide layer, and an electrode are sequentially stacked on a surface of the other side of the silicon substrate. Through the cooperation of the above structures, the heterojunction solar cell with excellent performance is obtained.

Further, film layer structures are also deposited on the sidewall of the silicon substrate in a direction perpendicular to the thickness direction of the silicon substrate. Starting from the surface of the sidewall, a first backside intrinsic layer, a frontside intrinsic layer, a frontside doped layer, a second backside intrinsic layer, and a backside doped layer are sequentially stacked. In addition, the outermost layer may further include a frontside transparent conductive oxide layer, and the film layer structures on the sidewall and corresponding film layer structures on the surface of the silicon substrate are integrally formed.

In a fourth aspect, the present disclosure also provides use of the heterojunction solar cell according to the second aspect in a photovoltaic device.

In a fifth aspect, the present disclosure provides a photovoltaic module. The photovoltaic module includes an upper glass layer, an upper encapsulant film layer, a cell string, a lower encapsulant film layer, and a lower glass layer. Cells in the cell string include the heterojunction solar cell according to the first aspect.

In a sixth aspect, the present disclosure provides a heterojunction solar cell. The heterojunction solar cell includes: a silicon substrate having a first surface, a second surface opposite to the first surface, and a sidewall surface connecting the first surface and the second surface; at least one backside intrinsic layer, a backside doped layer, a second transparent conductive oxide layer, and a second electrode that are sequentially stacked on the first surface, the backside doped layer being further disposed on the sidewall surface; at least one frontside intrinsic layer, a frontside doped layer, a first transparent conductive oxide layer, and a first electrode that are sequentially stacked on the second surface, the frontside doped layer being further disposed on the sidewall surface; a first intrinsic layer disposed between the frontside doped layer and the backside doped layer on the sidewall surface.

In an embodiment, the at least one backside intrinsic layer is further disposed on the sidewall surface, and the at least one backside intrinsic layer includes a plurality of backside intrinsic layers. The first intrinsic layer is at least one of the plurality of backside intrinsic layer disposed on the sidewall surface.

In an embodiment, the at least one frontside intrinsic layer is further disposed on the sidewall surface, and the at least one frontside intrinsic layer includes a plurality of frontside intrinsic layers.

In an embodiment, the at least one backside intrinsic layer includes a plurality of backside intrinsic layers, and the at least one frontside intrinsic layer includes a plurality of frontside intrinsic layers. The plurality of backside intrinsic layers and the plurality of frontside intrinsic layers being further disposed on the sidewall surface. The first intrinsic layer includes at least one of the plurality of backside intrinsic layer disposed on the sidewall surface.

In an implementation, a number of the frontside doped layer disposed on the second surface is two or more, and wherein on the second surface, a frontside doped layer among the two or more frontside doped layers that is in direct contact with the first transparent conductive oxide layer is an N-type doped amorphous silicon layer with a thickness ranging from 0.5 nm to 5 nm. Preferably, the thickness of the N-type doped amorphous silicon layer is 1.5 nm.

In an implementation, a number of the frontside doped layer disposed on the sidewall surface is one or more, and wherein on the sidewall surface, a frontside doped layer among the one or more frontside doped layers that is in direct contact with the first intrinsic layer is an N-type doped amorphous silicon layer with a thickness ranging from 0.1 nm to 2 nm.

In the above implementations, by configuring the frontside doped layer on the second surface (i.e., main light-receiving surface) of the silicon substrate as an N-type doped amorphous silicon layer with the thickness ranging from 0.5 nm to 5 nm, dual benefits can be achieved: on one hand, it can improve the frontside tunneling contact, and reduces front tunnel contact resistance during carrier tunneling, thereby enhancing photovoltaic conversion efficiency by approximately 0.055%; on the other hand, it can suppress the transmission of short-wave light on the frontside of the cell to reduce UV-induced degradation.

In addition, by configuring the frontside doped layer on the sidewall surface of the silicon substrate as an N-type doped amorphous silicon layer with the thickness ranging from 0.1 nm to 2 nm, UV light absorption at the peripheral edges of the solar cell is enhanced (particularly in TCO-free regions along the back edges where UV-induced degradation is severe), thereby further mitigating UV-induced degradation in the solar cell.

Notably, UV-induced degradation tends to be more pronounced at the edges of the solar cell than on the frontside or backside surfaces of the solar cell, which severely compromises the performance of the solar cell. The above implementations address this by optimizing the stacking structure of films at the sidewall surface of the solar cell and configuring the frontside doped layer in the films on the sidewall surfaces that is in direct contact with the first intrinsic layer as an amorphous silicon doped layer. Such design effectively counteracts ultraviolet irradiation-induced degradation and thereby significantly minimizing overall UV-induced degradation in the solar cell.

In an embodiment, the N-type doped amorphous silicon layer has a microstructure factor R of less than 0.5. Preferably, the microstructure factor R of the N-type doped amorphous silicon layer ranges from 0.05 to 0.2. For example, the microstructure factor R of the N-type doped amorphous silicon layer may be 0.07, 0.09, 0.1, 0.12, 0.14, 0.16, 0.18, 0.2, 0.3, 0.4, or 0.5. The microstructure factor R is defined as: R=I_{HSM}/(I_{HSM}+I_{LSM}). I_{HSM} denotes an absorption strength in High Stretching Mode (HSM), and I_{LSM} denotes an absorption strength in Low Stretching Mode (LSM). The Si-H stretching modes can be typically deconvoluted into the low stretching mode (LSM) at 1980 cm⁻¹ to 2010 cm⁻¹ and the high stretching mode (HSM) at 2070 cm⁻¹ to 2100 cm⁻¹ by Gaussian peak fitting.

By keeping the microstructure factor of the N-type doped amorphous silicon layer below 0.5, electron transport performance can be improved, electron mobility and cell conductivity can be enhanced, while the thermal stability of the film layer can be increased, enabling it to withstand temperature fluctuations during solar cell operation.

In an embodiment, the at least one backside intrinsic layer and the at least one frontside intrinsic layer is further disposed on the sidewall surface. The heterojunction solar cell further includes a second intrinsic layer and a third intrinsic layer that are disposed on the sidewall surface of the silicon substrate, the second intrinsic layer being in contact with the sidewall surface, and the third intrinsic layer being in contact with the second intrinsic layer at a side of the second intrinsic layer away from the sidewall surface. The second intrinsic layer at least includes a backside intrinsic layer among the at least one backside intrinsic layer that is disposed on the sidewall surface and in contact with the sidewall surface. The third intrinsic layer at least includes a frontside intrinsic layer among the at least one frontside intrinsic layer that is disposed on the sidewall surface and in contact with the second intrinsic layer.

In an embodiment, the first transparent conductive oxide layer is further disposed on a side of the backside doped layer of the sidewall surface facing away from the first intrinsic layer.

In an embodiment, the at least one backside intrinsic layer includes a first backside intrinsic layer and a second backside intrinsic layer, and the at least one frontside intrinsic layer comprises one frontside intrinsic layer, the first backside intrinsic layer, the second backside intrinsic layer and the frontside intrinsic layer being further disposed on the sidewall surface. The first intrinsic layer includes the second backside intrinsic layer disposed on the sidewall surface. The first backside intrinsic layer, the second backside intrinsic layer, the backside doped layer, the second transparent conductive oxide layer, and the second electrode are sequentially stacked on the first surface of the silicon substrate. The frontside intrinsic layer, the frontside doped layer, the first transparent conductive oxide layer, and the first electrode are sequentially stacked on the second surface of the silicon substrate. The first backside intrinsic layer, the frontside intrinsic layer, the frontside doped layer, the second backside intrinsic layer, the backside doped layer, and the first transparent conductive oxide layer are sequentially stacked on the sidewall surface of the silicon substrate.

In an embodiment, the second surface is a main light-receiving surface of the silicon substrate.

In an embodiment, the heterojunction solar cell is a rear junction heterojunction solar cell.

In an embodiment, the silicon substrate is an N-type silicon substrate; the backside doped layer is a P-type doped layer; and the frontside doped layer is an N-type doped silicon layer.

In an embodiment, the frontside intrinsic layer disposed on the sidewall surface of the silicon substrate doped thin thickness ranging from 0.5 nm to 2 nm; and/or the first intrinsic layer disposed on the sidewall surface of the silicon substrate has a thickness ranging from 0.5 nm to 2 nm.

In an embodiment, a second backside intrinsic layer disposed on the sidewall surface of the silicon substrate has a thickness ranging from 0.5 nm to 2 nm; and/ or the first backside intrinsic layer disposed on the sidewall surface of the silicon substrate has a thickness ranging from 0.5 nm to 2 nm; and/or the frontside intrinsic layer disposed on the sidewall surface of the silicon substrate has a thickness ranging from 0.5 nm to 2 nm; and/or the first transparent conductive oxide layer disposed on the sidewall surface of the silicon substrate has a thickness ranging from 0.5 nm to 20 nm.

In a seventh aspect, the present disclosure provides a method for preparing a heterojunction solar cell according to the sixth aspect. The method includes: depositing a first backside intrinsic layer on each of the first surface of the silicon substrate and the sidewall surface of the silicon substrate; depositing a frontside intrinsic layer and a frontside doped layer sequentially on each of the second surface of the silicon substrate and the first backside intrinsic layer of the sidewall surface; depositing a second backside intrinsic layer and a backside doped layer sequentially on each of the first backside intrinsic layer of the first surface and the frontside doped layer of the sidewall surface; depositing the first transparent conductive oxide layer on the frontside doped layer of the second surface, and depositing the second transparent conductive oxide layer on the backside doped layer of the first surface; and preparing an electrode on each of the first transparent conductive oxide layer and the second transparent oxide layer, to obtain the heterojunction solar cell.

In an embodiment, the second transparent conductive oxide layer is deposited on the backside doped layer of the first surface subsequent to the depositing of the first transparent conductive oxide layer on the frontside doped layer of the second surface.

In an embodiment, the depositing the first backside intrinsic layer on each of the first surface of the silicon substrate and the sidewall surface of the silicon substrate includes: simultaneously depositing, by introducing first silane gas, the first backside intrinsic layer on each of the first surface of the silicon substrate and the sidewall surface of the silicon substrate.

In an embodiment, the depositing the frontside intrinsic layer and the frontside doped layer sequentially on each of the second surface of the silicon substrate and the first backside intrinsic layer of the sidewall surface includes: simultaneously depositing, by introducing second silane gas, the frontside intrinsic layer on each of the second surface of the silicon substrate and the first backside intrinsic layer of the sidewall surface; and simultaneously depositing, by introducing second silane gas, first hydrogen gas, and first doping gas, the frontside doped layer on each of the frontside intrinsic layer of the second surface and the frontside intrinsic layer of the sidewall surface.

In an embodiment, simultaneously depositing the frontside doped layer on each of the frontside intrinsic layer of the second surface and the frontside intrinsic layer of the sidewall surface comprises: simultaneously depositing, under a deposition pressure ranging from 0.5 to 2 torr, an N-type doped amorphous silicon layer on each of the frontside intrinsic layer of the second surface and the frontside intrinsic layer of the sidewall surface, wherein the N-type doped amorphous silicon layer formed on the frontside intrinsic layer of the second surface has a thickness ranging from 0.5 nm to 5 nm, and the N-type doped amorphous silicon layer formed on the frontside intrinsic layer of the sidewall surface has a thickness ranging from 0.1 nm to 2 nm.

Specifically, during the deposition of the frontside doped amorphous silicon layer on each of the frontside intrinsic layer of the second surface and the frontside intrinsic layer of the sidewall surface of the silicon substrate, the process parameters are controlled as follows: deposition pressure ranging from 0.5 torr to2 torr, a ratio of hydrogen to silane ranging from 5:1 to 50:1, a ratio of phosphine to silane ranging from 1:1 to 10:1, and deposition temperature ranging from 180 °C to 230°C.

Specifically, setting the ratio of hydrogen to silane within the range of 5:1 to 50:1 enables the microstructure factor of the N-type doped amorphous silicon film layer to be below 0.5. In particular, the microstructure factor of the N-type doped amorphous silicon film layer may fall within the range of 0.05 to 0.2. For example, the microstructure factor of the N-type doped amorphous silicon film layer may be 0.07, 0.09, 0.1, 0.12, 0.14, 0.16, 0.18, 0.2, 0.3, 0.4, and 0.5.

By setting the ratio of hydrogen to silane within the range of 5:1 to 50:1, the microstructure factor of the N-type doped amorphous silicon layer can be maintained below 0.5, which improves electron transport performance, enhances electron mobility and battery conductivity, and increases the thermal stability of the film layer. This enhanced stability allows the film layer to better withstand temperature fluctuations encountered during solar cell operation.

In a preferred embodiment, depositing the frontside doped layer on each of the frontside intrinsic layer of the second surface and the frontside intrinsic layer of the sidewall surface comprises: simultaneously depositing, under a deposition pressure of 1.2 torr, an N-type doped amorphous silicon layer on each of the frontside intrinsic layer of the second surface and the frontside intrinsic layer of the sidewall surface, wherein the N-type doped amorphous silicon layer formed on the frontside intrinsic layer of the second surface has a thickness of 1.5 nm.

Specifically, during the deposition of the frontside doped amorphous silicon layer on the frontside intrinsic layer of each of the second surface and the sidewall surface of the silicon substrate, the process parameters are controlled as follows: deposition pressure ranging from 1.5 torr, a ratio of hydrogen to silane of 20:1, a ratio of phosphine to silane of 5:1, and deposition temperature of 200°C.

In an embodiment, the depositing the second backside intrinsic layer and the backside doped layer sequentially on each of the first backside intrinsic layer of the first surface and the frontside doped layer of the sidewall surface includes: simultaneously depositing, by introducing third silane gas and second hydrogen gas, the second backside intrinsic layer on the first backside intrinsic layer of the first surface and the frontside doped layer of the silicon substrate; and simultaneously depositing, by introducing fourth silane gas, third hydrogen, and second doping gas, the backside doped layer on each of the second backside intrinsic layer of the first surface and the second backside intrinsic layer of the sidewall surface.

In an embodiment, the preparing an electrode on each of the first transparent conductive oxide layer and the second transparent oxide layer comprises: preparing the electrode on the first transparent conductive oxide layer is performed subsequent to preparing the electrode on the second transparent conductive oxide layer.

In an embodiment, the first transparent conductive oxide layer when being deposited on the frontside doped layer of the second surface, is further deposited on the backside doped layer of the sidewall surface.

The numerical range includes not only the above-exemplified point values, but also any point values within the above-exemplified value ranges that are not listed. Due to a space limitation and for the sake of simplicity, the present disclosure does not exhaustively list the specific point values encompassed by the above-exemplified ranges.

The present disclosure has the following beneficial effects over the related art.

In the heterojunction solar cell according to the present disclosure, the second backside intrinsic layer is disposed between the backside doped layer (a p layer) and the first backside intrinsic layer, ensuring that there is no damage on the outermost backside intrinsic layer in contact with the p-doped layer, thus obtaining a low-resistance and stable tunneling contact. Moreover, the silicon substrate is also provided with a film layer structure at the sidewall of the silicon substrate, especially it is ensured that there is at least one backside intrinsic layer structure between the frontside doped layer (an n layer) and the backside doped layer (the p layer), making the insulation performance of the cell more excellent. Through the synthetic coordination of the stacking order of the film layers in the cell structure and the specific types of the structural layers, the insulation performance of the heterojunction solar cell is improved, and thus the heterojunction solar cell exhibits better tunneling contact and reduced thermal degradation. In this way, a significant improvement in the photoelectric conversion effect of the cell is achieved.

### BRIEF DESCRIPTION OF THE DRAWINGS

FIG. 1 is a schematic structural diagram of a heterojunction solar cell according to a specific embodiment of the present disclosure.
FIG. 2 is a schematic structural diagram of a heterojunction solar cell in a comparative example of the present disclosure.

1-silicon substrate, 2-first backside intrinsic layer, 3-frontside intrinsic layer, 4-frontside doped layer, 5-second backside intrinsic layer, 6-backside doped layer, 7-first transparent conductive oxide layer, 8-second transparent conductive oxide layer, 9-first electrode, 10-second electrode, L-thickness direction.

### DETAILED DESCRIPTION OF THE EMBODIMENTS

It is to be understood that, in the description of the present disclosure, terms such as "center", "longitudinal", "lateral", "over", "below", "front", "back", "left", "right", "vertical", "horizontal", "top", "bottom", "in", "out" refer to the directions and location relations which are the directions and location relations illustrated in the drawings, and for describing the present disclosure and for describing in simple, and which are not intended to indicate or imply that the device or the elements are disposed to locate at the specific directions or are structured and performed in the specific directions, which could not to be understood to the limitation of the present disclosure.

It should be noted that, in the description of the present disclosure, unless specified or limited otherwise, the terms "arranged", "mounted", "connected", and "coupled" are understood broadly, such as fixed, detachable mountings, connections and couplings or integrated, and can be mechanical or electrical mountings, connections and couplings, and also can be direct and via media indirect mountings, connections, and couplings, and further can be inner mountings, connections and couplings of two components. For those skilled in the art, the specific meaning of the above-mentioned terms in the embodiments of the present disclosure can be understood according to specific circumstances.

Heterojunction high-efficiency solar cells have advantages over other types in terms of an intrinsic amorphous layer, which provide both efficient passivation and tunneling. An interior of the intrinsic amorphous layer serves to suppress epitaxial growth to achieve effective passivation, and an exterior of the intrinsic amorphous layer forms an effective contact with a corresponding doped layer. At this stage, it is found that the tunneling contact on the backside of the cell significantly affects IV performance of the cell and directly correlates with thermal degradation. Thus, achieving better tunneling contact has become particularly crucial.

In existing coating technologies, deposition of a backside intrinsic layer (back i) and deposition of a backside doped layer are typically interspersed with a frontside coating process. For example, Chinese Patent Application CN109411551A discloses a method for preparing an electrode structure of a high-efficiency crystalline silicon heterojunction solar cell through multi-step deposition. The method includes: step 1 of selecting an N-type monocrystalline silicon wafer as a substrate, followed by for texturing and cleaning treatment; step 2 of preparing a dual intrinsic amorphous silicon layer on each of the frontside and backside by means of plasma-enhanced chemical vapor deposition, PECVD, where the intrinsic amorphous silicon layer on each of the frontside and the backside is deposited in multiple steps, with each step followed by H plasma treatment for 20 seconds to 60 seconds; step 3 of selecting an N-type amorphous silicon film as a doped layer of a light-receiving surface; step 4 of preparing an n-type amorphous silicon doped layer using the PECVD; and step 5 of preparing a p-type amorphous silicon doped layer using the PECVD. That is, during the above-mentioned coating deposition process, the frontside doped layer is deposited after the deposition of the backside intrinsic layer is completed. During the flip-coating process, friction between carriers, automation devices, and the like with contact surfaces is inevitably introduced, causing damage to the film layer, thereby affecting a contact effect with the backside doped layer.

In addition, due to a relatively thin silicon wafer substrate used in the heterojunction solar cell and limited coating process accuracy, edge short circuits or leakage currents of the heterojunction solar cell are prone to occur.

Therefore, for the heterojunction solar cell, achieving superior tunneling contact and reduced thermal degradation, and reducing probability of edge short circuits or reducing leakage currents are urgent technical problems that need to be addressed.

In order to at least partially solve the above technical problems, the present disclosure provides a heterojunction solar cell, a method for preparing a heterojunction solar cell, a photovoltaic module.

The technical solutions of the present disclosure will be further illustrated below through specific embodiments with reference to the accompanying drawings.

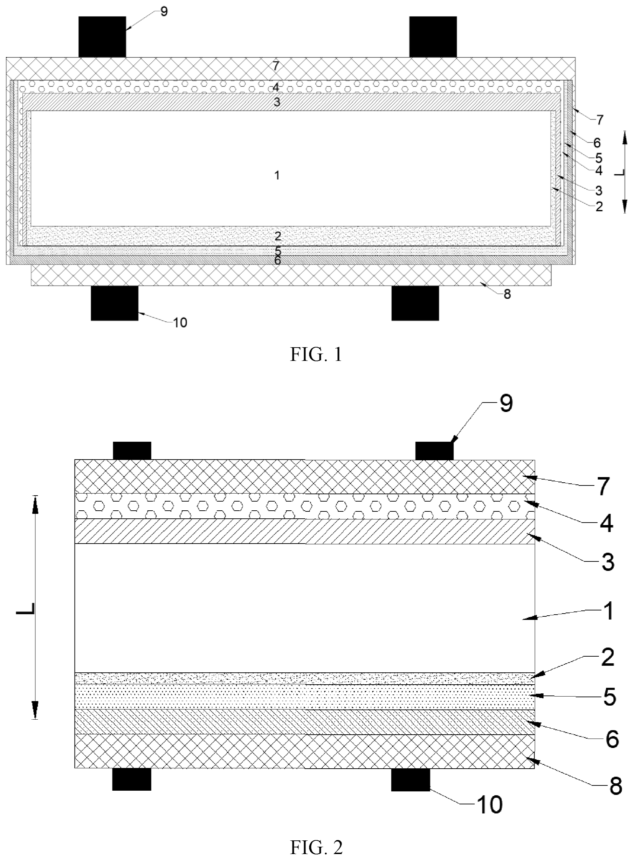

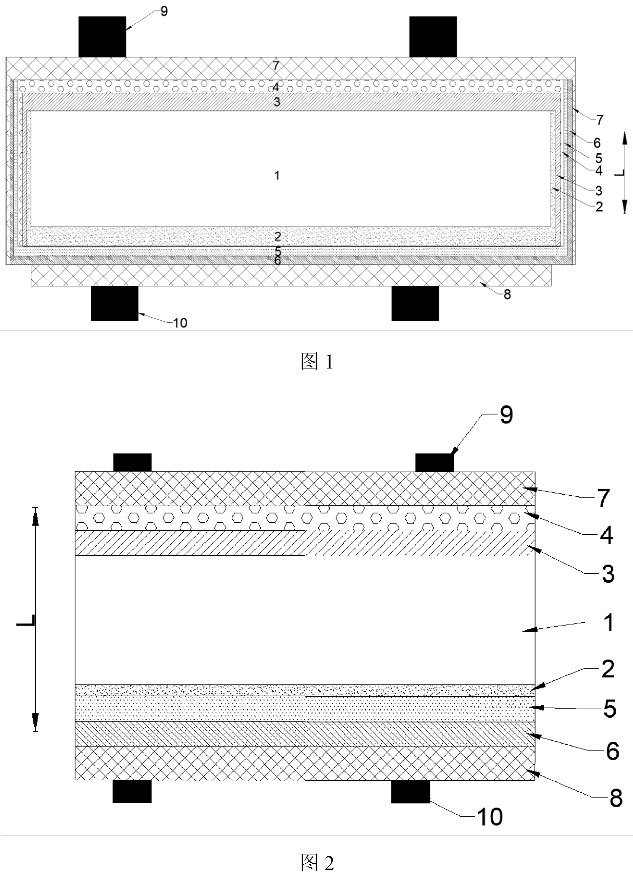

In a specific embodiment, the present disclosure provides a heterojunction solar cell, as shown in FIG. 1. The heterojunction solar cell includes: a silicon substrate 1; a frontside intrinsic layer 3, a frontside doped layer 4, a first transparent conductive oxide layer 7, and a first electrode 9 that are sequentially stacked on a main light-receiving surface of the silicon substrate 1 in a thickness direction L of the silicon substrate 1; a first backside intrinsic layer 2, a second backside intrinsic layer 5, a backside doped layer 6, a second transparent conductive oxide layer 8, and a second electrode 10 that are sequentially stacked on the other surface of the silicon substrate 10 opposite to the main light-receiving surface in the thickness direction L of the silicon substrate 1; the frontside doped layer 4, the second backside intrinsic layer 5, and the backside doped layer 6 stacked on a sidewall surface of the silicon substrate 1 from inside to outside in a horizontal direction perpendicular to the thickness direction L of the silicon substrate 1.

As a preferred technical solution in a specific embodiment, the silicon substrate 1 includes an N-type silicon substrate. The N-type silicon substrate has a resistivity ranging from 0.5 Q.cm to 3 Ω.cm and a thickness ranging from 90 µm to 120 µm.

As a preferred technical solution in a specific embodiment, the frontside doped layer 4 disposed on the sidewall surface of the silicon substrate 1 has a thickness ranging from 0.5 nm to 2 nm in a direction perpendicular to the thickness direction L of the silicon substrate 1.

As a preferred technical solution in a specific embodiment, the second backside intrinsic layer 5 disposed on the sidewall surface of the silicon substrate 1 has a thickness ranging from 0.5 nm to 2 nm in the horizontal direction perpendicular to the thickness direction L of the silicon substrate 1.

As a preferred technical solution in a specific embodiment, the backside doped layer 6 disposed on the sidewall surface of the silicon substrate 1 has a thickness ranging from 0.5 nm to 2 nm in the horizontal direction perpendicular to the thickness direction L of the silicon substrate 1.

As a preferred technical solution in a specific embodiment, in the horizontal direction perpendicular to the thickness direction L of the silicon substrate 1, the first backside intrinsic layer 2, the frontside intrinsic layer 3, the frontside doped layer 4, the second backside intrinsic layer 5, and the backside doped layer 6 are stacked on the sidewall surface of the silicon substrate 1 from inside to outside.

As a preferred technical solution in a specific embodiment, the first backside intrinsic layer 2 disposed on the sidewall surface of the silicon substrate 1 has a thickness ranging from 0.5 nm to 2 nm in the horizontal direction perpendicular to the thickness direction L of the silicon substrate 1.

As a preferred technical solution in a specific embodiment, the frontside intrinsic layer 3 disposed on the sidewall surface of the silicon substrate 1 has a thickness ranging from 0.5 nm to 2 nm in the horizontal direction perpendicular to the thickness direction L of the silicon substrate 1.

As a preferred technical solution in a specific embodiment, the first transparent conductive oxide layer 7 is further provided on the surface of the backside doped layer 6 away from the silicon substrate 1 in the horizontal direction perpendicular to the thickness direction L of the silicon substrate 1.

Further, the first transparent conductive oxide layer 7 disposed on the sidewall surface of the silicon substrate 1 has a thickness ranging from 0.5 nm to 2 nm in the horizontal direction perpendicular to the thickness direction L of the silicon substrate 1.

As a preferred technical solution in a specific embodiment, the frontside intrinsic layer is an intrinsic amorphous silicon film layer.

As a preferred technical solution in a specific embodiment, the frontside intrinsic layer 3 has a thickness ranging from 4.5 nm to 7.5 nm in the thickness direction L of the silicon substrate 1.

As a preferred technical solution in a specific embodiment, the frontside doped layer 4 has a thickness ranging from 25 nm to 35 nm in the thickness direction L of the silicon substrate 1.

As a preferred technical solution in a specific embodiment, the first backside intrinsic layer 2 has a thickness ranging from 1 nm to 2 nm in the thickness direction L of the silicon substrate 1.

As a preferred technical solution in a specific embodiment, the second backside intrinsic layer 5 has a thickness ranging from 3 nm to 6 nm in the thickness direction L of the silicon substrate 1.

As a preferred technical solution in a specific embodiment, the backside doped layer 6 has a thickness ranging from 25 nm to 35 nm in the thickness direction L of the silicon substrate 1.

As a preferred technical solution in a specific embodiment, each of the first transparent conductive oxide layer 7 and the second transparent conductive oxide layer 8 independently has a thickness ranging from 40 nm to 120 nm in the thickness direction L of the silicon substrate 1.

In an application embodiment, the photovoltaic module includes an upper glass layer, an upper encapsulant film layer, a cell string, a lower encapsulant film layer, and a lower glass layer. Cells in the cell string include the heterojunction solar cell as described in the above-mentioned specific embodiments.

It should be noted that the preparation process of the heterojunction solar cell in the present disclosure is possible, and raw materials, preparation conditions, and specific preparation sequence in each of the film layers can be adaptively selected and adjusted according to thickness and type requirements of the film layers.

Exemplarily, the present disclosure provides a method for preparing a heterojunction solar cell. The method is as follows.
(1) Selection of a silicon substrate: An N-type crystal silicon wafer is selected, which has a resistivity ranging from 0.5 Ω.cm to 3 Ω.cm, for example, 1 Ω.cm, a thickness of 100 µm, and a size of 210mm.
(2) Cleaning and texturing: An oxide layer on a surface of the silicon substrate is removed using a 5% diluted HF solution; and the KOH combined with alcohol was adopted to form pyramidal structures on the surface of the silicon substrate through anisotropic etching of monocrystalline silicon, thereby completing the texturing treatment on both surfaces of the silicon substrate.
(3) Deposition of a first backside intrinsic layer: SiH₄ (silane) gas is introduced into a vacuum chamber, and the first backside intrinsic layer is formed on an entire region of each of a first surface of the silicon substrate and a sidewall along a thickness direction of the silicon substrate through PECVD. An inflow flow rate of the silane gas ranges from 800 sccm to 1000 sccm, a pressure ranges from 0.4 Torr to 0.6 Torr, and a deposition power ranges from 500 W to 1000 W. The first backside intrinsic layer deposited on the first surface of the silicon substrate (e.g., the non-light-receiving surface opposite to the light-receiving surface) has a thickness ranging from 1 nm to 2 nm, and the first backside intrinsic layer deposited on the sidewall along the thickness direction of the silicon substrate has a thickness ranging from 0.5 nm to 1 nm.
(4) Deposition of a frontside intrinsic layer and a frontside doped layer: The silicon substrate is flipped to expose a surface of the other side (i.e., a second surface) of the silicon substrate, and a tray of the silicon substrate is replaced. SiH₄ (silane) gas is introduced into the vacuum chamber, and the frontside intrinsic layer is formed on an entire region of each of the second surface and the sidewall along the thickness direction of the silicon substrate through the PECVD. An inflow flow rate of the silane gas ranges from 500 sccm to 1000 sccm, a pressure ranges from 0.4 Torr to 0.6 Torr, and a deposition power ranges from 200 W to 600 W. The frontside intrinsic layer deposited on the second surface (e.g., the light-receiving surface) of the silicon substrate has a thickness ranging from 4.5 nm to 7.5 nm, and the frontside intrinsic layer deposited on the sidewall along the thickness direction of the silicon substrate has a thickness ranging from 0.5 nm to 1 nm.

Then, SiH₄ gas, H₂ gas, and PH₃ (phosphine, first doped gas) gas are introduced into the vacuum chamber, and the frontside doped layer is formed on the frontside intrinsic layer through the PECVD. An inlet flow rate of the silane gas ranges from 40 sccm to 70 sccm, an inlet flow rate of the hydrogen gas ranges from 12000 sccm to 16000 sccm, an inlet flow rate of the PH₃ gas ranges from 200 sccm to 500 sccm, a pressure ranges from 4 Torr to 6 Torr, and a deposition power ranges from 2000 W to 5000 W. The frontside doped layer deposited on the light-receiving surface has a thickness ranging from 25 nm to 35 nm, and the frontside doped layer deposited on the sidewall along the thickness direction of the silicon substrate has a thickness ranging from 0.5 nm to 2 nm.

(5) Deposition of a second backside intrinsic layer and a backside doped layer: The silicon substrate is flipped again, and the tray is replaced. Then, SiH₄ (silane) gas and hydrogen gas are introduced into the vacuum chamber, and the second backside intrinsic layer is formed on an entire region of the first backside intrinsic layer through the PECVD. In the introduced gas, a ratio of an inlet flow rate of the hydrogen gas to an inlet flow rate of the silane gas is (1 to 5):1. The inlet flow rate of the silane gas ranges from 500 sccm to 1000 sccm, and the inlet flow rate of the hydrogen gas ranges from 500 sccm to 5000 sccm. A pressure ranges from 0.4 Torr to 0.6 Torr, and a deposition power ranges from 100 W to 300 W. The second backside intrinsic layer 5 deposited on the non-light-receiving surface has a thickness ranging from 3 nm to 6nm, and the second backside intrinsic layer deposited on the sidewall along the thickness direction of the silicon substrate has a thickness ranging from 0.5 nm to 2 nm.

Then, SiH₄ gas, H₂ gas, and B₂H₆ (diborane, second doped gas) gas are introduced into the vacuum chamber, and the backside doped layer is formed on the second backside intrinsic layer through the PECVD. An inlet flow rate of the silane gas ranges from 50 sccm to 80 sccm, an inlet flow rate of the hydrogen gas ranges from 18000 sccm to 25000 sccm, an inlet flow rate of the B₂H₆ gas ranges from 30 sccm to 200 sccm. A pressure ranges from 3 Torr to 6 Torr, and a deposition power ranges from 5000 W to 8000 W. The backside doped layer deposited on the non-light-receiving surface has a thickness ranging from 25 nm to 35 nm, and the backside doped layer deposited on the sidewall along the thickness direction of the silicon substrate has a thickness ranging from 0.5 nm to 2nm.

(6) Deposition of a transparent conductive oxide film (TCO): An amorphous silicon thin film layer on each of the frontside and backside using RPD is coated using reactive plasma deposition (RPD). For the backside, edge shielding was implemented through a carrier disc design (via mask shielding). A specific shielding region around the perimeter is 0.8 mm, the TCO is made of ITO (99.5:0.5), which has a film thickness ranging from 40 nm to 120 nm, a carrier concentration of 3E20/cm³, and a mobility of 80 cm²/Vs.

(7) Preparation of an electrode: A layer of low-temperature conductive paste (e.g., silver paste) is printed on the transparent conductive oxide film on each of the frontside and backside using a screen printing method, and then sintering and curing are performed at a low temperature of 200°C, to form good ohmic contact.

(8) Light injection treatment: The obtained cell obtained in step (7) is subjected to the light injection treatment. A temperature of the light injection treatment is 210°C, and a duration of the light injection treatment is 90 seconds.

FIG. 1 shows a structural schematic diagram of a heterojunction solar cell prepared by the method according to the present disclosure. As illustrated in FIG. 1, in the thickness direction of the silicon substrate 1 (an arrow direction in FIG. 1 represents the thickness direction), the first backside intrinsic layer 2, the second backside intrinsic layer 5, and the backside doped layer 6 are disposed on a surface of one side of the silicon substrate 1. The frontside intrinsic layer 3 and the frontside doped layer 4 are sequentially disposed on a surface of the other side of the silicon substrate 1. The transparent conductive oxide layer 7 is disposed on each of the frontside doped layer 4 and the backside doped layer 6. The electrode 8 is disposed on the transparent conductive oxide layer 7. In addition, the first backside intrinsic layer 2, the frontside intrinsic layer 3, the frontside doped layer 4, the second backside intrinsic layer 5, the backside doped layer 6, and the transparent conductive oxide layer 7 located on the surface of the frontside doped layer 4 are sequentially disposed on the sidewall of the silicon substrate 1 in a direction perpendicular to the thickness direction of the silicon substrate 1. The heterojunction solar cell prepared by the method according to Example 1 has a low-resistance and stable tunneling contact, and its thermal degradation is also reduced.

Examples 1 to 12 and Comparative Examples 1 to 4 of the preparation method according to the present disclosure are given below.

### Example 1

This example provided a method for preparing a heterojunction solar cell. The method was as follows.
(1) Selection of a silicon substrate: An N-type crystal silicon wafer was selected, which had a resistivity of 1 Ω.cm, a thickness of 100 µm, and a size of 210 mm.
(2) Cleaning and texturing: An oxide layer on a surface of the silicon substrate was removed using a 5% diluted HF solution; and the KOH combined with alcohol was adopted to form pyramidal structures on the surface of the silicon substrate through anisotropic etching of monocrystalline silicon, thereby completing the texturing treatment on both surfaces of the silicon substrate.
(3) Deposition of a first backside intrinsic layer: SiH₄ (silane) gas was introduced into a vacuum chamber, and the first backside intrinsic layer (an amorphous silicon film il layer) was formed on an entire region of each of a first surface of the silicon substrate and a sidewall along a thickness direction of the silicon substrate through PECVD. An inflow flow rate of the silane gas was 900 sccm, a pressure was 0.5 Torr, and a deposition power was 800 W. The first backside intrinsic layer deposited on the first surface of the silicon substrate (a non-light-receiving surface opposite to a light-receiving surface) had a thickness of 2 nm, and a first backside intrinsic layer deposited on the sidewall of the silicon substrate had a thickness of 0.8 nm in a direction perpendicular to the thickness direction of the silicon substrate.
(4) Deposition of a frontside intrinsic layer and a frontside doped layer: The silicon substrate was flipped to expose the other surface (i.e., a second surface) of the silicon substrate, and a tray of the silicon substrate was replaced. SiH₄ (silane) gas was introduced into the vacuum chamber, and the frontside intrinsic layer was formed on an entire region of each of the second surface of the silicon substrate and a sidewall along the thickness direction of the silicon substrate through the PECVD. An inflow flow rate of the silane gas was 800 sccm, a pressure was 0.5 Torr, and a deposition power was 400 W. The frontside intrinsic layer deposited on the second surface (e.g., the light-receiving surface) of the silicon substrate had a thickness of 6.5 nm, and the frontside intrinsic layer deposited on the sidewall had a thickness of 0.8 nm in the direction perpendicular to the thickness direction of the silicon substrate.

Then, SiH₄ gas, H₂ gas, and PH₃ (phosphine, first doped gas) gas were introduced into the vacuum chamber, and the frontside doped layer was formed on the frontside intrinsic layer through the PECVD. An inlet flow rate of the silane gas was 55 sccm, an inlet flow rate of the hydrogen gas was 14000 sccm, and an inlet flow rate of the PH₃ gas was 350 sccm. A pressure was 5 Torr, and a deposition power was 3500 W. The frontside doped layer deposited on the light-receiving surface had a thickness of 25 nm, and the frontside doped layer deposited on the sidewall of the silicon substrate had a thickness of 0.8 nm in the direction perpendicular to the thickness direction of the silicon substrate.

(5) Deposition of a second backside intrinsic layer and a backside doped layer: The silicon substrate is flipped again, and the tray is replaced. Then, SiH₄ (silane) gas and hydrogen gas were introduced into the vacuum chamber, and the second backside intrinsic layer was formed on an entire region of the first backside intrinsic layer through the PECVD. In the introduced gas, a ratio of an inlet flow rate of the hydrogen gas to an inlet flow rate of the silane gas was 2.5:1. The inlet flow rate of the silane gas was 750 sccm. A pressure was 0.5 Torr, and a deposition power was 200 W. The second backside intrinsic layer deposited on the non-light-receiving surface had a thickness of 4 nm, and the second backside intrinsic layer deposited on the sidewall had a thickness of 0.8 nm in the direction perpendicular to the thickness direction of the silicon substrate.

Then, SiH₄ gas, H₂ gas, and B₂H₆ (diborane, second doped gas) gas were introduced into the vacuum chamber, and the backside doped layer was formed on the second backside intrinsic layer through the PECVD. An inlet flow rate of the silane gas was 65 sccm, an inlet flow rate of the hydrogen gas was 21000 sccm, an inlet flow rate of the B₂H₆ gas was 100 sccm. A pressure was 5 Torr, and a deposition power was 6500 W. The backside doped layer deposited on the non-light-receiving surface had a thickness of 30 nm, and the backside doped layer deposited on the sidewall had a thickness of 0.8 nm in the direction perpendicular to the thickness direction of the silicon substrate.

(6) Deposition of a transparent conductive oxide film (TCO): An amorphous silicon thin film layer on each of the frontside and backside was coated using reactive plasma deposition (RPD). For the backside, edge shielding was implemented through a carrier disc design (via mask shielding). A specific shielding region around the perimeter was 0.8 mm, the TCO was made of ITO (99.5:0.5), which had a film thickness of 40 nm, a carrier concentration of 3E20/cm³, and a mobility of 80 cm²/Vs.

(7) Preparation of an electrode: A layer of low-temperature conductive paste (e.g., silver paste) was printed on the transparent conductive oxide film on each of the frontside and backside using a screen printing method, and then sintering and curing were performed at a low temperature of 200°C, to form good ohmic contact.

(8) Light injection treatment: The obtained cell obtained in step (7) was subjected to the light injection treatment. A temperature of the light injection treatment was 210°C, and a duration of the light injection treatment was 90 seconds.

### Example 2

This example provided a method for preparing a heterojunction solar cell. The method was as follows.
(1) Selection of a silicon substrate: An N-type crystal silicon wafer was selected, which had a resistivity of 2 Ω.cm, a thickness of 100 µm, and a size of 210 mm.
(2) Cleaning and texturing: An oxide layer on a surface of the silicon substrate was removed using a 5% diluted HF solution; and the KOH combined with alcohol was adopted to form pyramidal structures on the surface of the silicon substrate through anisotropic etching of monocrystalline silicon, thereby completing the texturing treatment on both surfaces of the silicon substrate.
(3) Deposition of a first backside intrinsic layer: SiH₄ (silane) gas was introduced into a vacuum chamber, and the first backside intrinsic layer (an amorphous silicon film il layer) was formed on an entire region of each of a first surface of the silicon substrate and a sidewall along a thickness direction of the silicon substrate through PECVD. An inflow flow rate of the silane gas was 800 sccm, a pressure was 0.4 Torr, and a deposition power was 500 W. The first backside intrinsic layer deposited on the first surface of the silicon substrate (e.g., the non-light-receiving surface opposite to the light-receiving surface) had a thickness of 1 nm, and the first backside intrinsic layer deposited on the sidewall had a thickness of 0.5 nm in the direction perpendicular to the thickness direction of the silicon substrate.
(4) Deposition of a frontside intrinsic layer and a frontside doped layer: The silicon substrate was flipped to expose the other surface (i.e., a second surface) of the silicon substrate, and a tray of the silicon substrate was replaced. SiH₄ (silane) gas was introduced into the vacuum chamber, and the frontside intrinsic layer was formed on an entire region of each of the second surface of the silicon substrate and the sidewall along the thickness direction of the silicon substrate through the PECVD. An inflow flow rate of the silane gas was 500 sccm, a pressure was 0.4 Torr, and a deposition power was 200 W. The frontside intrinsic layer deposited on the second surface (e.g., the light-receiving surface) of the silicon substrate had a thickness of 5 nm, and the frontside intrinsic layer deposited on the sidewall had a thickness of 0.5 nm in the direction perpendicular to the thickness direction of the silicon substrate.

Then, SiH₄ gas, H₂ gas, and PH₃ (phosphine, first doped gas) gas were introduced into the vacuum chamber, and the frontside doped layer was formed on the frontside intrinsic layer through the PECVD. An inlet flow rate of the silane gas was 40 sccm, an inlet flow rate of the hydrogen gas was 12000 sccm, and an inlet flow rate of the PH₃ gas was 200 sccm. A pressure was 4 Torr, and a deposition power was 2000 W. The frontside doped layer deposited on the light-receiving surface had a thickness of 22 nm, and the frontside doped layer deposited on the sidewall had a thickness of 0.5 nm in the direction perpendicular to the thickness direction of the silicon substrate.

(5) Deposition of a second backside intrinsic layer and a backside doped layer: The silicon substrate is flipped again, and the tray is replaced. Then, SiH₄ (silane) gas and hydrogen gas were introduced into the vacuum chamber, and the second backside intrinsic layer was formed on an entire region of the first backside intrinsic layer through the PECVD. In the introduced gas, a ratio of an inlet flow rate of the hydrogen gas to an inlet flow rate of the silane gas was 5:1. The inlet flow rate of the silane gas was 500 sccm. A pressure was 0.4 Torr, and a deposition power was 200 W. The second backside intrinsic layer deposited on the non-light-receiving surface had a thickness of 3 nm, and the second backside intrinsic layer deposited on the sidewall had a thickness of 0.5 nm in the direction perpendicular to the thickness direction of the silicon substrate.

Then, SiH₄ gas, H₂ gas, and B₂H₆ (diborane, second doped gas) gas were introduced into the vacuum chamber, and the backside doped layer was formed on the second backside intrinsic layer through the PECVD. An inlet flow rate of the silane gas was 50 sccm, an inlet flow rate of the hydrogen gas was 18000 sccm, an inlet flow rate of the B₂H₆ gas was 30 sccm. A pressure was 4 Torr, and a deposition power was 5000 W. The backside doped layer deposited on the non-light-receiving surface had a thickness of 24 nm, and the backside doped layer deposited on the sidewall had a thickness of 0.5 nm in the direction perpendicular to the thickness direction of the silicon substrate.

(6) Deposition of a transparent conductive oxide film (TCO) perpendicular to the thickness direction of the silicon substrate: The amorphous silicon thin film layer on each of the frontside and backside are coated using reactive plasma deposition (RPD). For the backside, edge shielding was implemented through a carrier disc design (via mask shielding). A specific shielding region around the perimeter was 0.8 mm, the TCO was made of ITO (99.5:0.5), which had a film thickness of 40 nm, a carrier concentration of 4E20/cm³, and a mobility of 80 cm²/Vs.

(7) Preparation of an electrode: A layer of low-temperature conductive silver paste was printed on the transparent conductive oxide film on each of the frontside and backside using a screen printing method, and then sintering and curing were performed at a low temperature of 200°C, to form good ohmic contact.

(8) Light injection treatment: The obtained cell obtained in step (7) was subjected to the light injection treatment. A temperature of the light injection treatment was 210°C, and a duration of the light injection treatment was 90 seconds.

### Example 3

This example provided a method for preparing a heterojunction solar cell. The method was as follows.
(1) Selection of a silicon substrate: An N-type crystal silicon wafer was selected, which had a resistivity of 3 Ω.cm, a thickness of 90 µm, and a size of 210 mm.
(2) Cleaning and texturing: An oxide layer on a surface of the silicon substrate was removed using a 5% diluted HF solution; and the KOH combined with alcohol was adopted to form pyramidal structures on the surface of the silicon substrate through anisotropic etching of monocrystalline silicon, thereby completing the texturing treatment on both surfaces of the silicon substrate.
(3) Deposition of a first backside intrinsic layer: SiH₄ (silane) gas was introduced into a vacuum chamber, and the first backside intrinsic layer (an amorphous silicon film il layer) was formed on an entire region of each of a first surface of the silicon substrate and a sidewall in a thickness direction of the silicon substrate through PECVD. An inflow flow rate of the silane gas was 1000 sccm, a pressure was 0.6 Torr, and a deposition power was 1000 W. The first backside intrinsic layer deposited on the surface of the silicon substrate (e.g., a non-light-receiving surface opposite to a light-receiving surface) had a thickness of 1.5 nm, and a first backside intrinsic layer deposited on the sidewall of the silicon substrate had a thickness of 1.5 nm in the direction perpendicular to the thickness direction of the silicon substrate.
(4) Deposition of a frontside intrinsic layer and a frontside doped layer: The silicon substrate was flipped to expose the other surface (i.e., a second surface) of the silicon substrate, and a tray of the silicon substrate was replaced. SiH₄ (silane) gas was introduced into the vacuum chamber, and the frontside intrinsic layer was formed on an entire region of the second surface of the silicon substrate and the sidewall along the thickness direction of the silicon substrate through the PECVD. An inflow flow rate of the silane gas was 1000 sccm, a pressure was 0.6 Torr, and a deposition power was 600 W. The frontside intrinsic layer deposited on the other side surface (the light-receiving surface) of the silicon substrate had a thickness of 85 nm, and the frontside intrinsic layer deposited on the sidewall had a thickness of 2 nm in the direction perpendicular to the thickness direction of the silicon substrate.

Then, SiH₄ gas, H₂ gas, and PH₃ (phosphine, first doped gas) gas were introduced into the vacuum chamber, and the frontside doped layer was formed on the frontside intrinsic layer through the PECVD. An inlet flow rate of the silane gas was 70 sccm, an inlet flow rate of the hydrogen gas was 16000 sccm, and an inlet flow rate of the PH₃ gas was 500 sccm. A pressure was 6 Torr, and a deposition power was 5000 W. The frontside doped layer deposited on the light-receiving surface had a thickness of 28 nm, and the frontside doped layer deposited on the sidewall had a thickness of 2 nm in the direction perpendicular to the thickness direction of the silicon substrate.

(5) Deposition of a second backside intrinsic layer and a backside doped layer: The silicon substrate is flipped again, and the tray is replaced. Then, SiH₄ (silane) gas and hydrogen gas were introduced into the vacuum chamber, and the second backside intrinsic layer was formed on an entire region of the first backside intrinsic layer through the PECVD. In the introduced gas, a ratio of an inlet flow rate of the hydrogen gas to an inlet flow rate of the silane gas was 1:1. The inlet flow rate of the silane gas was 1000 sccm. A pressure was 0.6 Torr, and a deposition power was 300 W. The second backside intrinsic layer deposited on the non-light-receiving surface had a thickness of 6 nm, and the second backside intrinsic layer deposited on the sidewall had a thickness of 2 nm in the direction perpendicular to the thickness direction of the silicon substrate.

Then, SiH₄ gas, H₂ gas, and B₂H₆ (diborane, second doped gas) gas were introduced into a vacuum chamber, and the backside doped layer was formed on a second backside intrinsic layer through the PECVD. An inlet flow rate of the silane gas was 80 sccm, an inlet flow rate of the hydrogen gas was 25000 sccm, an inlet flow rate of the B₂H₆ gas was 200 sccm. A pressure was 6 Torr, and a deposition power was 8000 W. The backside doped layer deposited on the non-light-receiving surface had a thickness of 35 nm, and the backside doped layer deposited on the sidewall perpendicular to the thickness direction of the silicon substrate had a thickness of 2 nm.

(6) Deposition of a transparent conductive oxide film (TCO) perpendicular to the thickness direction of the silicon substrate: The amorphous silicon thin film layer on each of the frontside and backside are coated using reactive plasma deposition (RPD). For the backside, edge shielding was implemented through a carrier disc design (via mask shielding). A specific shielding region around the perimeter was 0.8 mm, the TCO was made of ITO (99.5:0.5), which had a film thickness of 40 nm, a carrier concentration of 5E20/cm³, and a mobility of 80 cm²/Vs.

(7) Preparation of an electrode: A layer of low-temperature conductive silver paste was printed on the transparent conductive oxide film on each of the frontside and backside using a screen printing method, and then sintering and curing were performed at a low temperature of 200°C, to form good ohmic contact.

(8) Light injection treatment: The obtained cell obtained in step (7) was subjected to the light injection treatment. A temperature of the light injection treatment was 210°C, and a duration of the light injection treatment was 90 seconds.

### Example 4

This example differed from Example 1 in step (3), where an inlet flow rate of the silane gas was 500 sccm.

The remaining preparation processes and parameters were consistent with those of Example 1.

### Example 5

This example differed from Example 1 in step (3), where an inlet flow rate of the silane gas was 1500 sccm.

The remaining preparation processes and parameters were consistent with those of Example 1.

### Example 6

This example differed from Example 1 in step (3), where the first backside intrinsic layer deposited on the first surface of the silicon substrate (a non-light-receiving surface opposite to a light-receiving surface) had a thickness of 3 nm.

The remaining preparation processes and parameters were consistent with those of Example 1.

### Example 7

This example differed from Example 1 in step (5), where an inflow flow rate ratio of the hydrogen gas and the silane gas was 0.5:1 when depositing the second backside intrinsic layer.

The remaining preparation processes and parameters were consistent with those of Example 1.

### Example 8

This example differed from Example 1 in step (5), where an inflow flow rate ratio of the hydrogen gas and the silane gas was 10:1 when depositing the second backside intrinsic layer.

The remaining preparation processes and parameters were consistent with those of Example 1.

### Example 9

This example differed from Example 1 in step (5), where the second backside intrinsic layer deposited on the non-light-receiving surface had a thickness of 1.5 nm.

The remaining preparation processes and parameters were consistent with those of Example 1.

### Example 10

This example differed from Example 1 in step (5), where the second backside intrinsic layer deposited on the non-light-receiving surface had a thickness of 8 nm.

The remaining preparation processes and parameters were consistent with those of Example 1.

### Example 11

This example differed from Example 1 in steps (2) to (5), where no film layer structures were deposited on the sidewall of the silicon substrate in the direction perpendicular to the thickness direction of the silicon substrate.

The remaining preparation processes and parameters were consistent with those of Example 1.

### Example 12

This example differed from Embodiment 1 in step (5), where no second backside intrinsic layer was deposited at the sidewall of the silicon substrate in the direction perpendicular to the thickness direction of the silicon substrate, that is, there was no film layer structure between the frontside doped layer (n layer) and the backside doped layer (p layer) on the sidewall.

The remaining preparation processes and parameters were consistent with those of Example 1.

### Comparative Example 1

This comparative example provided a method for preparing a heterojunction solar cell. The method was as follows.
(1) Selection of a silicon substrate: An N-type crystal silicon wafer was selected, which had a resistivity of 1 Ω.cm, a thickness of 100 µm, and a size of 210 mm.
(2) Cleaning and texturing: An oxide layer on a surface of the silicon substrate was removed using a 5% diluted HF solution; and the KOH combined with alcohol was adopted to form pyramidal structures on the surface of the silicon substrate through anisotropic etching of monocrystalline silicon, thereby completing the texturing treatment on both surfaces of the silicon substrate.
(3) Deposition of a frontside intrinsic layer and a frontside doped layer: The silicon substrate was flipped to expose the other surface (i.e., a second surface) of the silicon substrate, and a tray of the silicon substrate was replaced. SiH₄ (silane) gas was introduced into a vacuum chamber, and the frontside intrinsic layer was formed on an entire region of each of the second surface and a sidewall of the silicon substrate (the sidewall along a thickness direction of the silicon substrate) through the PECVD. An inflow flow rate of the silane gas was 800 sccm, a pressure was 0.5 Torr, and a deposition power was 400 W. The frontside intrinsic layer deposited on the second surface (the light-receiving surface) of the silicon substrate had a thickness of 6.5 nm, and the frontside intrinsic layer deposited on the sidewall had a thickness of 0.8 nm in a direction perpendicular to the thickness direction of the silicon substrate.

Then, SiH₄ gas, H₂ gas, and PH₃ (phosphine, first doped gas) gas were introduced into the vacuum chamber, and the frontside doped layer was formed on the frontside intrinsic layer through the PECVD. An inlet flow rate of the silane gas was 55 sccm, an inlet flow rate of the hydrogen gas was 14000 sccm, and an inlet flow rate of the PH₃ gas was 350 sccm. A pressure was 5 Torr, and a deposition power was 3500 W. The frontside doped layer deposited on the light-receiving surface had a thickness of 25 nm, and the frontside doped layer deposited on the sidewall had a thickness of 0.8 nm in the direction perpendicular to the thickness direction of the silicon substrate.

(4) Deposition of a first backside intrinsic layer, a second backside intrinsic layer, and a backside doped layer:

The silicon substrate was flipped, and the tray was replaced. SiH₄ (silane) gas was introduced into the vacuum chamber, and the first backside intrinsic layer (an amorphous silicon film il layer) was formed on an entire region of a first surface of the silicon substrate and the sidewall of the silicon substrate through PECVD. An inflow flow rate of the silane gas was 900 sccm, a pressure was 0.5 Torr, and a deposition power was 800 W. The first backside intrinsic layer deposited on the first surface of the silicon substrate (a non-light-receiving surface opposite to the light-receiving surface) had a thickness of 2 nm, and a first backside intrinsic layer deposited on the sidewall had a thickness of 0.8 nm in the direction perpendicular to the thickness direction of the silicon substrate.

Then, SiH₄ (silane) gas and hydrogen gas were introduced into the vacuum chamber, and the second backside intrinsic layer was formed on an entire region of the first backside intrinsic layer through the PECVD. In the introduced gas, a ratio of an inlet flow rate of the hydrogen gas to an inlet flow rate of the silane gas was 2.5:1. The inlet flow rate of the silane gas was 750 sccm. A pressure was 0.5 Torr, and a deposition power was 200 W. The second backside intrinsic layer deposited on the non-light-receiving surface had a thickness of 4 nm, and the second backside intrinsic layer deposited on the sidewall had a thickness of 0.8 nm in the direction perpendicular to the thickness direction of the silicon substrate.

Deposition of a second backside intrinsic layer and a backside doped layer: The silicon substrate is flipped again, and the tray is replaced. Then, SiH₄ (silane) gas and hydrogen gas were introduced into the vacuum chamber, and the second backside intrinsic layer was formed on an entire region of the first backside intrinsic layer through the PECVD. In the introduced gas, a ratio of an inlet flow rate of the hydrogen gas to an inlet flow rate of the silane gas was 2.5:1. The inlet flow rate of the silane gas was 750 sccm. A pressure was 0.5 Torr, and a deposition power was 200 W. The second backside intrinsic layer deposited on the non-light-receiving surface had a thickness of 4 nm, and the second backside intrinsic layer deposited on the sidewall had a thickness of 0.8 nm in the direction perpendicular to the thickness direction of the silicon substrate.

(5) Deposition of a transparent conductive oxide film (TCO): The amorphous silicon thin film layer on each of the frontside and backside was coated using reactive plasma deposition (RPD). For the backside, edge shielding was implemented through a carrier disc design (via mask shielding). A specific shielding region around the perimeter was 0.8 mm, the TCO was made of ITO (99.5:0.5), which had a film thickness of 40 nm, a carrier concentration of 3E20/cm³, and a mobility of 80 cm²/Vs.

(6) Preparation of an electrode: A layer of low-temperature conductive silver paste was printed on the transparent conductive oxide film on each of the frontside and a backside using a screen printing method, and then sintering and curing were performed at a low temperature of 200°C, to form good ohmic contact.

(7) Light injection treatment: The obtained cell obtained in step (6) was subjected to the light injection treatment. A temperature of the light injection treatment was 210°C, and a duration of the light injection treatment was 90 seconds.

### Comparative Example 2

This comparative example differed from Example 1 in that, no first backside intrinsic layer was prepared.

The remaining preparation processes and parameters were consistent with those of Example 1.

### Comparative Example 3

This comparative example differed from Example 1 in that, no second backside intrinsic layer was prepared.

The remaining preparation processes and parameters were consistent with those of Example 1.

### Comparative Example 4

This comparative example differed from Example 1 in that, the preparation order of the first backside intrinsic layer and the second backside intrinsic layer was reversed.

The remaining preparation processes and parameters were consistent with those of Example 1.

Performance tests were conducted on the solar cells prepared in Examples 1 to 12 and Comparative Examples 1 to 4, including tests for open-circuit voltage (Voc), fill factor (FF), short-circuit current density (Jsc), conversion efficiency (eta), and thermal degradation (ΔEff). The specific test results are shown in Table 1.

**[Table 1]**

| | **Voc (mV)** | **FF (%)** | **Jsc (mA/cm²)** | **Eta (%)** | **ΔEff degradation** |
|---|---|---|---|---|---|
| Example 1 | 749.8 | 85.10 | 41.18 | 26.28 | 0.5% |
| Example 2 | 749.5 | 85.15 | 41.17 | 26.28 | 0.55% |
| Example 3 | 750.5 | 85.06 | 41.15 | 26.27 | 0.5% |
| Example 4 | 749.1 | 84.99 | 41.15 | 26.20 | 0.73% |
| Example 5 | 749.3 | 85.02 | 41.16 | 26.22 | 0.81% |
| Example 6 | 750.7 | 84.91 | 41.15 | 26.23 | 0.55% |
| Example 7 | 750.5 | 85.00 | 41.17 | 26.26 | 0.60% |
| Example 8 | 749.2 | 84.89 | 41.16 | 26.18 | 0.70% |
| Example 9 | 749.1 | 85.0 | 41.17 | 26.21 | 0.75% |
| Example 10 | 749.8 | 84.92 | 41.16 | 26.21 | 0.78% |
| Example 11 | 748.4 | 84.87 | 41.12 | 26.12 | 0.90% |
| Example 12 | 748.8 | 84.88 | 41.10 | 26.12 | 0.90% |
| Comparative Example 1 | 749.9 | 84.75 | 41.15 | 26.15 | 1.0% |
| Comparative Example 2 | 748.3 | 84.90 | 41.10 | 26.11 | 1.2% |
| Comparative Example 3 | 748.8 | 84.80 | 41.15 | 26.13 | 1.3% |
| Comparative Example 4 | 749.0 | 84.80 | 41.14 | 26.13 | 1.3% |

In summary, in the preparation method according to the present disclosure, with the synthetic coordination of the preparation sequence and the structural layers, destruction of the intrinsic layer is avoided when flipping the silicon substrate for the frontside coating (i.e., the light-receiving surface) by preparing the backside intrinsic layer in steps, ensuring that an outermost backside intrinsic layer in contact with the backside doped layer remains intact. Thus, the solar cell structure with the low-resistance and stable tunneling contact is obtained, and its thermal degradation is also reduced.

Heterojunction solar cells provided in Examples 13 to 20 and Comparative Example 5 are obtained by adopting the above-mentioned preparation method with adaptive selection and adjustment.

### Example 13

This example provides a heterojunction solar cell, which is provided based on the above-mentioned specific embodiments. The heterojunction solar cell includes: a silicon substrate 1; a frontside intrinsic layer 3, a frontside doped layer 4, a first transparent conductive oxide layer 7, and a first electrode 9 that are sequentially stacked on a main light-receiving surface of the silicon substrate 1 in a thickness direction L of the silicon substrate 1; a first backside intrinsic layer 2, a second backside intrinsic layer 5, a backside doped layer 6, a second transparent conductive oxide layer 8, and a second electrode 10 that are sequentially stacked on the other surface opposite to the main light-receiving surface of the silicon substrate 1 in the thickness direction L of the silicon substrate 1.
a first backside intrinsic layer 2, a frontside intrinsic layer 3, a frontside intrinsic layer 4, a second backside intrinsic layer 5, a backside intrinsic layer 6, and a first transparent conductive oxide layer 7 that are stacked on a sidewall surface of the silicon substrate 1 in a horizontal direction perpendicular to the thickness direction L of the silicon substrate 1.

In addition, in the thickness direction L of the silicon substrate 1, the silicon substrate 1 has a thickness of 100 µm, the frontside intrinsic layer 3 has a thickness of 5 nm, and the frontside doped layer 4 has a thickness of 25 nm; the first backside intrinsic layer 2 has a thickness of 2 nm, the second backside intrinsic layer 5 has a thickness of 5 nm, the backside doped layer 6 has a thickness of 25 nm, and each of the first transparent conductive layer 7 and the second transparent conductive layer 8 has a thickness of 40 nm.

Each of the film layer structures stacked on the sidewall surface of the silicon substrate 1 has a thickness of 0.5 nm in the horizontal direction perpendicular to the thickness direction L of the silicon substrate 1.

### Example 14

This example provides a heterojunction solar cell, which is provided based on the above-mentioned specific embodiments. The heterojunction solar cell includes: a silicon substrate 1; a frontside intrinsic layer 3, a frontside doped layer 4, a first transparent conductive oxide layer 7, and a first electrode 9 that are sequentially stacked on a main light-receiving surface of the silicon substrate 1 in a thickness direction L of the silicon substrate 1; a first backside intrinsic layer 2, a second backside intrinsic layer 5, a backside doped layer 6, a second transparent conductive oxide layer 8, and a second electrode 10 that are sequentially stacked on the other surface opposite to the main light-receiving surface of the silicon substrate 1 in the thickness direction L of the silicon substrate; a first backside intrinsic layer 2, a frontside intrinsic layer 3, a frontside intrinsic layer 4, a second backside intrinsic layer 5, a backside intrinsic layer 6, and a first transparent conductive oxide layer 7 that are stacked on a sidewall surface of the silicon substrate 1 in a horizontal direction perpendicular to the thickness direction L of the silicon substrate 1.

In addition, in the thickness direction L of the silicon substrate 1, the silicon substrate 1 has a thickness of 100 µm, the frontside intrinsic layer 3 has a thickness of 7.5 nm, and the frontside doped layer 4 has a thickness of 32 nm; the first backside intrinsic layer 2 has a thickness of 2 nm, the second backside intrinsic layer 5 has a thickness of 5 nm, the backside doped layer 6 has a thickness of 32 nm, and each of the first transparent conductive layer 7 and the second transparent conductive layer 8 has a thickness of 40 nm.

Each of the film layer structures stacked on the sidewall surface of the silicon substrate 1 has a thickness of 2 nm in the horizontal direction perpendicular to the thickness direction L of the silicon substrate 1.

### Example 15

This example provides a heterojunction solar cell, which is provided based on the above-mentioned specific embodiments. The heterojunction solar cell includes: a silicon substrate 1; a frontside intrinsic layer 3, a frontside doped layer 4, a first transparent conductive oxide layer 7, and a first electrode 9 that are sequentially stacked on a main light-receiving surface of the silicon substrate 1 in a thickness direction L of the silicon substrate 1; a first backside intrinsic layer 2, a second backside intrinsic layer 5, a backside doped layer 6, a second transparent conductive oxide layer 8, and a second electrode 10 that are sequentially stacked on the other surface opposite to the main light-receiving surface of the silicon substrate 1 in the thickness direction L of the silicon substrate 1; a first backside intrinsic layer 2, a frontside intrinsic layer 3, a frontside intrinsic layer 4, a second backside intrinsic layer 5, a backside intrinsic layer 6, and a first transparent conductive oxide layer 7 that stacked on a sidewall surface of the silicon substrate 1 in a horizontal direction perpendicular to the thickness direction L of the silicon substrate 1.

In addition, in the thickness direction L of the silicon substrate 1, the silicon substrate 1 has a thickness of 100 µm, the frontside intrinsic layer 3 has a thickness of 6.5 nm, and the frontside doped layer 4 has a thickness of 29 nm; the first backside intrinsic layer 2 has a thickness of 2 nm, the second backside intrinsic layer 5 has a thickness of 5 nm, the backside doped layer 6 has a thickness of 29 nm, and each of the first transparent conductive layer 7 and the second transparent conductive layer 8 has a thickness of 40 nm.

Each of the film layer structures stacked on the sidewall surface of the silicon substrate 1 has a thickness of 0.8 nm in the horizontal direction perpendicular to the thickness direction L of the silicon substrate 1.

### Example 16

This example differed from Example 13 in that, the first backside intrinsic layer 2 has a thickness of 3 nm in the thickness direction L of the silicon substrate 1.

The remaining structure and parameters of the heterojunction solar cell are consistent with those of Example 13.

### Example 17

This example differed from Example 13 in that, the first backside intrinsic layer 2 has a thickness of 0.5 nm in the thickness direction L of the silicon substrate 1.

The remaining structure and parameters of the heterojunction solar cell are consistent with those of Example 13.

### Example 18

This example differed from Example 13 in that, the second backside intrinsic layer 5 has a thickness of 7 nm in the thickness direction L of the silicon substrate 1.

The remaining structure and parameters of the heterojunction solar cell are consistent with those of Example 13.

### Example 19

This example differs from Example 13 in that, the second backside intrinsic layer 5 has a thickness of 2 nm in the thickness direction L of the silicon substrate 1.

The remaining structure and parameters of the heterojunction solar cell are consistent with those of Example 13.

### Example 20

This example differs from Example 13 in that, each of the film layer structures stacked on the sidewall surface of the silicon substrate 1 has a thickness of 2.5 nm in the direction perpendicular to the thickness direction L of the silicon substrate 1.

The remaining structure and parameters of the heterojunction solar cell are consistent with those of Example 13.

### Comparative Example 5

Comparative Example 5 differs from Example 13 in that, as shown in FIG. 2, no film layer structures are stacked on the sidewall surface of the silicon substrate 1 in the direction perpendicular to the thickness direction L of the silicon substrate 1.

The remaining structure and parameters of the heterojunction solar cell are consistent with those of Example 13.

AFM1.5 performance tests were conducted on the solar cells prepared in Examples 13 to 20 and Comparative Example 5, including tests for open-circuit voltage (Voc), fill factor (FF), short-circuit current density (Jsc), conversion efficiency (eta), and thermal degradation (ΔEff). The specific test results are shown in Table 1.

**[Table 1]**

| | Voc (mV) | FF (%) | Jsc (mA/cm²) | eta (%) | ΔEff degradation |
|---|---|---|---|---|---|
| Example 13 | 749.8 | 85.10 | 41.18 | 26.31 | 0.5% |
| Example 14 | 749.6 | 85.2 | 41.16 | 26.29 | 0.55% |
| Example 15 | 750.2 | 85.05 | 41.2 | 26.29 | 0.55% |
| Example 16 | 750.4 | 84.8 | 41.2 | 26.22 | 0.62% |
| Example 17 | 749.1 | 85.1 | 41.18 | 26.25 | 0.70% |
| Example 18 | 750.3 | 84.9 | 41.18 | 26.23 | 0.55% |
| Example 19 | 748.8 | 85.2 | 41.16 | 26.25 | 0.8% |
| Example 20 | 749.8 | 85.15 | 41.10 | 26.24 | 0.55% |
| Comparative Example 5 | 748.8 | 85.10 | 41.10 | 26.19 | 1.2% |

While the specific embodiments of the present disclosure have been described above, the scope of the present disclosure is not limited to these embodiments. It should be understood by those skilled in the art that various modifications and alternatives that can be easily conceived by any of those skilled in the art shall fall within the scope of the present disclosure.

## Claims

1. A heterojunction solar cell, comprising:
a silicon substrate having a first surface, a second surface opposite to the first surface, and a sidewall surface connecting the first surface and the second surface;
at least one backside intrinsic layer, a backside doped layer, a second transparent conductive oxide layer, and a second electrode that are sequentially stacked on the first surface, the backside doped layer being further disposed on the sidewall surface;
at least one frontside intrinsic layer, a frontside doped layer, a first transparent conductive oxide layer, and a first electrode that are sequentially stacked on the second surface, the frontside doped layer being further disposed on the sidewall surface; and
a first intrinsic layer disposed between the frontside doped layer and the backside doped layer on the sidewall surface.

2. The heterojunction solar cell according to claim 1, wherein the at least one backside intrinsic layer is further disposed on the sidewall surface, and the at least one backside intrinsic layer comprises a plurality of backside intrinsic layers,
wherein the first intrinsic layer is at least one of the plurality of backside intrinsic layers disposed on the sidewall surface.

3. The heterojunction solar cell according to claim 1 or 2, wherein a number of the frontside doped layer disposed on the second surface is two or more, and wherein on the second surface, a frontside doped layer among the two or more frontside doped layers that is in direct contact with the first transparent conductive oxide layer is an N-type doped amorphous silicon layer with a thickness ranging from 0.5 nm to 5 nm.

4. The heterojunction solar cell according to any one of claims 1 to 3, wherein a number of the frontside doped layer disposed on the sidewall surface is one or more, and wherein on the sidewall surface, a frontside doped layer among the one or more frontside doped layers that is in direct contact with the first intrinsic layer is an N-type doped amorphous silicon layer with a thickness ranging from 0.1 nm to 2 nm.

5. The heterojunction solar cell according to claim 3, wherein the N-type doped amorphous silicon layer has a microstructure factor of less than 0.5.

6. The heterojunction solar cell according to any one of claims 1 to 5, wherein the at least one backside intrinsic layer and the at least one frontside intrinsic layer are further disposed on the sidewall surface,
the heterojunction solar cell further comprises: a second intrinsic layer and a third intrinsic layer that are disposed on the sidewall surface of the silicon substrate, the second intrinsic layer being in contact with the sidewall surface, and the third intrinsic layer being in contact with the second intrinsic layer at a side of the second intrinsic layer away from the sidewall surface, wherein:
the second intrinsic layer at least comprises a backside intrinsic layer among the at least one backside intrinsic layer that is disposed on the sidewall surface and in contact with the sidewall surface; and
the third intrinsic layer at least comprises a frontside intrinsic layer among the at least one frontside intrinsic layer that is disposed on the sidewall surface and in contact with the second intrinsic layer.

7. The heterojunction solar cell according to claim 1, wherein
the first transparent conductive oxide layer is further disposed on a side of the backside doped layer of the sidewall surface facing away from the first intrinsic layer.

8. The heterojunction solar cell according to claim 7, wherein:
the at least one backside intrinsic layer comprises a first backside intrinsic layer and a second backside intrinsic layer, and the at least one frontside intrinsic layer comprises one frontside intrinsic layer, the first backside intrinsic layer, the second backside intrinsic layer and the frontside intrinsic layer being further disposed on the sidewall surface; and
the first intrinsic layer comprises the second backside intrinsic layer disposed on the sidewall surface, wherein:
the first backside intrinsic layer, the second backside intrinsic layer, the backside doped layer, the second transparent conductive oxide layer, and the second electrode are sequentially stacked on the first surface of the silicon substrate;
the frontside intrinsic layer, the frontside doped layer, the first transparent conductive oxide layer, and the first electrode are sequentially stacked on the second surface of the silicon substrate; and
the first backside intrinsic layer, the frontside intrinsic layer, the frontside doped layer, the second backside intrinsic layer, the backside doped layer, and the first transparent conductive oxide layer are sequentially stacked on the sidewall surface of the silicon substrate.

9. The heterojunction solar cell according to any one of claims 1 to 8, wherein the second surface is a main light-receiving surface of the silicon substrate; and/or
wherein the heterojunction solar cell is a rear junction heterojunction solar cell; and/or wherein the silicon substrate is an N-type silicon substrate, the backside doped layer is a P-type doped layer, and the frontside doped layer is an N-type doped silicon layer.

10. The heterojunction solar cell according to claim 8, wherein:
the frontside doped layer disposed on the sidewall surface of the silicon substrate has a thickness ranging from 0.5 nm to 2 nm; and/or
the first intrinsic layer disposed on the sidewall surface of the silicon substrate has a thickness ranging from 0.5 nm to 2 nm; and/or
the second backside intrinsic layer disposed on the sidewall surface of the silicon substrate has a thickness ranging from 0.5 nm to 2 nm; and/or
the first backside intrinsic layer disposed on the sidewall surface of the silicon substrate has a thickness ranging from 0.5 nm to 2 nm; and/or
the frontside intrinsic layer disposed on the sidewall surface of the silicon substrate has a thickness ranging from 0.5 nm to 2 nm; and/or
the first transparent conductive oxide layer disposed on the sidewall surface of the silicon substrate has a thickness ranging from 0.5 nm to 20 nm.

11. A method for preparing the heterojunction solar cell according to any one of claims 1 to 10, the method comprising:
depositing a first backside intrinsic layer on each of the first surface of the silicon substrate and the sidewall surface of the silicon substrate;
depositing a frontside intrinsic layer and a frontside doped layer sequentially on each of the second surface of the silicon substrate and the first backside intrinsic layer of the sidewall surface;
depositing a second backside intrinsic layer and a backside doped layer sequentially on each of the first backside intrinsic layer of the first surface and the frontside doped layer of the sidewall surface;
depositing the first transparent conductive oxide layer on the frontside doped layer of the second surface, and depositing the second transparent conductive oxide layer on the backside doped layer of the first surface; and
preparing an electrode on each of the first transparent conductive oxide layer and the second transparent oxide layer, to obtain the heterojunction solar cell.

12. The method for preparing the heterojunction solar cell according to claim 11, wherein the second transparent conductive oxide layer is deposited on the backside doped layer of the first surface subsequent to the depositing of the first transparent conductive oxide layer on the frontside doped layer of the second surface.

13. The method for preparing the heterojunction solar cell according to claim 11 or 12,
wherein said depositing the first backside intrinsic layer on each of the first surface of the silicon substrate and the sidewall surface of the silicon substrate comprises:
simultaneously depositing, by introducing first silane gas, the first backside intrinsic layer on each of the first surface of the silicon substrate and the sidewall surface of the silicon substrate; and/or
wherein said depositing the frontside intrinsic layer and the frontside doped layer sequentially on each of the second surface of the silicon substrate and the first backside intrinsic layer of the sidewall surface comprises:
simultaneously depositing, by introducing second silane gas, the frontside intrinsic layer on each of the second surface of the silicon substrate and the first backside intrinsic layer of the sidewall surface; and
simultaneously depositing, by introducing second silane gas, first hydrogen gas, and first doping gas, the frontside doped layer on each of the frontside intrinsic layer of the second surface and the frontside intrinsic layer of the sidewall surface; and/or
said depositing the second backside intrinsic layer and the backside doped layer sequentially on each of the first backside intrinsic layer of the first surface and the frontside doped layer of the sidewall surface comprises:
simultaneously depositing, by introducing third silane gas and second hydrogen gas, the second backside intrinsic layer on the first backside intrinsic layer of the first surface and the frontside doped layer of the silicon substrate; and
simultaneously depositing, by introducing fourth silane gas, third hydrogen, and second doping gas, the backside doped layer on each of the second backside intrinsic layer of the first surface and the second backside intrinsic layer of the sidewall surface.

14. The method for preparing the heterojunction solar cell according to claim 11 or 12, wherein said depositing the frontside intrinsic layer and the frontside doped layer sequentially on each of the second surface of the silicon substrate and the first backside intrinsic layer of the sidewall surface comprises:
simultaneously depositing, under a deposition pressure ranging from 0.5 to 2 torr, an N-type doped amorphous silicon layer on each of the frontside intrinsic layer of the second surface and the frontside intrinsic layer of the sidewall surface,
wherein the N-type doped amorphous silicon layer formed on the frontside intrinsic layer of the second surface has a thickness ranging from 0.5 nm to 5 nm, and the N-type doped amorphous silicon layer formed on the frontside intrinsic layer of the sidewall surface has a thickness ranging from 0.1 nm to 2 nm.

15. The method for preparing the heterojunction solar cell according to any one of claim 11 to 14, wherein the first transparent conductive oxide layer, when being deposited on the frontside doped layer of the second surface, is further deposited on the backside doped layer of the sidewall surface.
